# FASCICULE DE BREVET EUROPEEN

(11) **EP 4 505 511 B1**
(45) Date de publication et mention de la délivrance du brevet: **18.03.2026**
(21) Numéro de dépôt: 23714548.7
(22) Date de dépôt: 28.03.2023
(51) Int. Cl.: H01L 21/768, H01L 23/48

(54) **SUBSTRAT COMPRENANT DES VIAS ET PROCÉDÉS DE FABRICATION ASSOCIÉS**
SUBSTRAT MIT VIAS UND ZUGEHÖRIGE HERSTELLUNGSVERFAHREN
SUBSTRATE CONTAINING VIAS AND ASSOCIATED FABRICATING PROCESSES

(30) Priorité: 06.04.2022 FR 2203158
(43) Date de publication de la demande: 12.02.2025
(73) Titulaire: Commissariat à l'Energie Atomique et aux Energies Alternatives, 75015 Paris (FR); SOITEC, 38190 Bernin (FR)
(72) Inventeur: CHARBONNIER, Jean, 38054 Grenoble Cedex 09 (FR); COUDRAIN, Perceval, 38054 Grenoble Cedex 09 (FR); COUTIER, Caroline, 38054 Grenoble Cedex 09 (FR); GHYSELEN, Bruno, 38170 Seyssinet Pariset (FR); SALVETAT, Thierry, 38054 Grenoble Cedex 09 (FR)
(74) Mandataire: Hautier IP
(86) Numéro de dépôt international: PCT/EP2023/057901
(87) Numéro de publication internationale: WO 2023/194142

(56) Documents cités:
- US-A1- 2021 407 890

## Description

### DOMAINE TECHNIQUE DE L'INVENTION

La présente invention concerne le domaine des substrats destinés à fabriquer des dispositifs électroniques et plus particulièrement des dispositifs microélectroniques. Ces substrats peuvent permettre *in fine* un raccordement électrique et mécanique d'éléments électriques de composants. L'invention trouve pour application avantageuse, mais non limitative, la fabrication de dispositifs microélectroniques.

### ETAT DE LA TECHNIQUE

Il existe un intérêt pour fabriquer des dispositifs microélectroniques en utilisant des vias s'étendant perpendiculairement au plan d'extension principale du substrat. Cela peut être particulièrement intéressant pour la fabrication de microsystèmes électromécaniques (abrégé MEMS, de l'anglais *MicroElectroMechanical Systems*). Cela peut en outre être particulièrement intéressant pour la fabrication d'assemblages de composants sur des substrats comprenant des vias pour former des contacts traversants afin de pouvoir intercon-necter ces composants en face avant et en face arrière d'un substrat, pour obtenir un dispositif microélectronique. Les composants peuvent ainsi être connectés à un circuit imprimé par exemple par le biais d'un boîtier. Ces substrats peuvent notamment être des substrats semi-conducteurs, par exemple de type semi-conducteur sur isolant, et notamment silicium-sur-isolant SOI (abrégé de l'anglais *Silicon-On-Insulator*).

La gravure et le remplissage de ces vias (communément désignés TSV, abrégé de l'anglais *Through-Silicon-Via* pour les substrats à base de silicium) par un matériau électriquement conducteur ou semi-conducteur, sont des étapes de procédé assez spécifiques et souvent réalisées chez les assembleurs (communément désignés OSAT, de l'anglais *Out-sourced Semi-conductor Assembly and Test)* et non les fondeurs.

US 2021/407890 A1 divulgue une pluralité de vias à travers du silicium.

On distingue deux types de vias selon leur moment de fabrication dans la chaîne de fabrication d'un dispositif microélectronique. Les vias dit « TSV-middle » sont généralement fabriqués en milieu de procédé, après la fabrication des motifs d'un composant lors du *Front-end-of-line* (abrégé FEOL, que l'on peut traduire par début de ligne de fabrication) mais avant le dépôt des couches métalliques du *Back-end-of-line* (abrégé BEOL, que l'on peut traduire par fin de ligne de fabrication). Cela demande généralement un transfert du substrat et des composants du fondeur à l'assembleur pour la fabrication des vias, ensuite un retour au fondeur pour les étapes du BEOL, et enfin encore un transfert à l'assembleur pour finaliser le procédé. Ces étapes de fabrication sont très contraintes en termes de planéité, de contamination, ce qui est peu compatible avec ces allers-retours entre fondeur et assembleur.

Les vias « TSV-last » peuvent être fabriqués en fin de procédé, après les étapes du FEOL et du BEOL. Cela demande généralement un seul transfert du fondeur à l'assembleur, après les étapes du BEOL. Toutefois, les géométries de vias ainsi réalisables sont limitées. Notamment, la densité de vias pouvant être obtenue est limitée.

Il existe donc un besoin pour obtenir ces structures sans dépendre des autres étapes de fabrication de la chaîne.

Un objet de la présente invention est donc de faciliter la fabrication de vias dans un dispositif microélectronique.

Les autres objets, caractéristiques et avantages de la présente invention apparaîtront à l'examen de la description suivante et des dessins d'accompagnement. Il est entendu que d'autres avantages peuvent être incorporés.

### RESUME DE L'INVENTION

Pour atteindre cet objectif, selon un premier aspect on prévoit un substrat, notamment pour dispositif microélectronique, comprenant :
- une première couche à base, et de préférence faite, d'un matériau semi-conducteur,
- une deuxième couche surmontant la première couche.

Le substrat comprend une pluralité de vias enterrés s'étendant depuis la deuxième couche sur une portion de la première couche, chaque via étant délimité par une paroi latérale, une paroi de fond, et une paroi supérieure opposée à la paroi de fond, et au moins un ensemble de la pluralité de vias forme un motif se répétant le long d'au moins une direction du plan d'extension principale des première et deuxième couches.

Ainsi, le substrat est générique et comprend des vias non-débouchants préalablement remplis ou configurés pour le remplissage par un organe conducteur électriquement ou semi-conducteur ultérieur. Ceci permet de fournir les vias indépendamment des autres étapes de réalisation d'un dispositif microélectronique. Le substrat comprenant les vias enterrés peut être utilisé pour réaliser le dépôt de couches, par exemple du FEOL et du BEOL, puis les vias peuvent être utilisés pour réaliser l'organe électriquement conducteur ou semi-conducteur désiré, par exemple des interconnexions électriques. En outre, les vias étant fabriqués au préalable, les géométries des vias ne sont pas limitées.

Le substrat comporte une matrice de vias qu'il est possible de sélectionner en totalité ou en partie afin de réaliser les organes électriquement conducteurs ou semi-conducteurs désirés au plus adapté de la géométrie voulue. Le substrat générique comprenant ces vias permet donc de faciliter la fabrication des vias et de l'organe conducteur ou semi-conducteur, en pouvant notamment s'adapter à différents dispositifs microélectroniques.

On comprend donc que la fabrication des vias est facilitée, notamment au regard des autres étapes de fabrication d'un dispositif microélectronique, en permettant de s'adapter à différents dispositifs microélectroniques avec un même substrat générique. La fabrication des vias remplis par l'organe électriquement conducteur ou semi-conducteur, est plus particulièrement facilitée.

Un deuxième aspect concerne un procédé de fabrication du substrat, comprenant :
- une fourniture d'un sous-substrat support comprenant au moins une première couche à base d'un matériau semi-conducteur, le sous-substrat support présentant une surface exposée,
- la formation d'une pluralité de vias de sorte que les vias s'étendent depuis la surface exposée sur une portion de la première couche, chaque via étant délimité par une paroi latérale et une paroi de fond, au moins un ensemble de vias formant un motif se répétant le long d'au moins une direction du plan d'extension principale des première et deuxième couches,

- une fourniture d'un sous-substrat donneur comprenant une couche superficielle présentant une surface exposée,
- un assemblage du sous-substrat support et du sous-substrat donneur par leurs surfaces exposées, de façon à recouvrir les vias, chaque via étant alors délimité par la paroi latérale, la paroi de fond, et une paroi supérieure opposée à la paroi de fond.

Ce procédé permet ainsi la fabrication de la matrice de vias enterrés sur le substrat. Ce procédé présente les effets et avantages décrits relativement au premier aspect.

Un troisième aspect concerne un procédé de fabrication d'un dispositif microélectronique comprenant :
- une fourniture d'un substrat selon le premier aspect et/ou d'un substrat fabriqué par le procédé selon le deuxième aspect, présentant une surface exposée avant et une surface exposée arrière,
- une formation d'au moins une portion de couche du dispositif par un dépôt de ladite portion, sur au moins l'une parmi les surfaces exposées avant ou arrière du substrat, par exemple une première surface exposée, et par exemple la surface exposée avant, et/ou une gravure d'au moins l'une parmi les surfaces exposées avant ou arrière du substrat, par exemple la première surface exposée, et par exemple la surface exposée avant, configurée de façon à former ladite portion,
- au niveau d'au moins un via, une gravure par l'une parmi les surfaces exposées avant ou arrière du substrat, par exemple une deuxième surface exposée distincte de la première, et par exemple la surface exposée arrière, jusqu'à atteindre le via, et :
   ∘ poursuivre la gravure pour atteindre l'au moins une portion de couche du dispositif, ou
   ∘ au niveau de l'au moins un via, une gravure par l'autre parmi les surfaces exposées avant ou arrière du substrat, par exemple par la première surface exposée, et par exemple la surface exposée avant, jusqu'à atteindre le via,
- le dépôt d'au moins un organe électriquement conducteur ou semi-conducteur de façon à mettre en continuité électrique au moins le via et la portion de couche de dispositif, par exemple en outre avec la surface avant et/ou arrière du substrat.

Ainsi, le substrat fourni permet la formation d'un dispositif microélectronique, puis l'ouverture de vias enterrés pour réaliser l'organe électriquement conducteur ou semi-conducteur voulu. Cela peut être réalisé de façon facilitée par rapport aux solutions existantes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A et 1B représentent respectivement des vues en coupe transversale et en coupe dans le plan d'extension principale des première et deuxième couches, du substrat selon un exemple de réalisation.
Les figures 2A à 2C représentent des vues en coupe de différentes configurations de vias.
Les figures 3A et 3B représentent respectivement des vues en coupe transversale et en coupe dans le plan d'extension principale des première et deuxième couches, du substrat selon un autre exemple de réalisation.
Les figures 4A à 4E représentent des vues en coupe transversale des étapes du procédé de fabrication du substrat selon un exemple de réalisation.
Les figures 5A à 5D représentent des vues en coupe transversale des étapes du procédé de fabrication du substrat selon un autre exemple de réalisation.
Les figures 6A à 6D représentent des vues en coupe transversale des étapes du procédé de fabrication du dispositif microélectronique selon un exemple de réalisation.
Les figures 7 et 8A à 8D représentent des vues en coupe transversale des étapes du procédé de fabrication du dispositif microélectronique selon deux autres exemples de réalisation.
Les figures 9A à 9C représentent des vues en coupe transversale des étapes du procédé de fabrication du dispositif microélectronique selon un exemple dans lequel un via comprend plusieurs portions présentant chacune une configuration différente.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des sous-substrats et substrat, des couches, des vias et des parois ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

Selon un exemple, pour au moins une partie des vias, et par exemple pour chaque via, les vias sont au moins en partie remplis de matériau(x).

Selon un exemple, chaque via présente au moins une dimension transversale comprise entre 1 µm et 30 µm. Selon un exemple, toutes les dimensions transversales de chaque via sont comprises entre 1 µm et 30 µm.

Selon un exemple, au moins une partie des vias, et de préférence chaque via, présente un rapport de forme supérieur ou égal à 10, de dimensions la plus longue orientée suivant une dimension en épaisseur des première et deuxième couches. Ce facteur de forme est particulièrement adapté pour obtenir une grande densité de via sur le substrat, et notamment en synergie avec les gammes de valeurs de pas énoncées plus loin.

Selon un exemple, au sein d'un ensemble de vias, deux motifs de vias, par exemple deux vias, se répétant successivement sont séparés par un pas constant suivant au moins une direction du plan d'extension principale des première et deuxième couches.

Selon un exemple, le pas est sensiblement compris entre 50 µm et 300 µm, de préférence entre 100 µm et 200 µm. Ce pas permet une meilleure densité des vias dans le substrat. Ainsi, une plus grande densité d'interconnexion est possible. En outre, l'adaptabilité du substrat à différents dispositif microélectronique est améliorée.

Selon un exemple, le substrat comprend plusieurs ensembles de vias formant chacun un motif se répétant le long d'au moins une direction du plan d'extension principale des première et deuxième couches. Le substrat générique peut ainsi comprendre différents agencements de motifs de via pour s'adapter à des dispositifs microélectroniques variés.

Selon un exemple, au moins un via, et de préférence au moins une partie de la pluralité de vias, et de préférence chaque via, présente au moins une configuration de via dans laquelle :
- la paroi latérale du via est faite d'un matériau diélectrique, et le via est rempli d'un matériau électriquement conducteur ou semi-conducteur ou le via est creux,
- la paroi latérale du via est faite d'un matériau diélectrique, et le via est rempli du matériau de la première couche,
- la paroi latérale du via est faite du matériau de la première couche et le via est creux.

Les vias peuvent donc être pleins ou creux, et éventuellement déjà isolés électriquement de la première couche. Lorsque la paroi latérale du via est faite d'un matériau diélectrique, les vias formés dans le substrat présentent une couche diélectrique au moins sur leur paroi latérale, préalablement à l'utilisation du substrat dans un procédé de fabrication d'un dispositif microélectronique. La paroi en matériau diélectrique étant formée au préalable, elle permet une bonne isolation des vias une fois remplis par le matériau conducteur ou semi-conducteur, tout en étant compatible avec les étapes du FEOL ou de montage temporaire d'un support.

Selon un exemple, au moins un via, et de préférence au moins une partie de la pluralité de vias, et de préférence chaque via d'au moins un ensemble, présente une première configuration de via sur une première portion, et une deuxième configuration de via distincte de la première configuration de via sur une deuxième portion, les première et deuxième portions s'étendant successivement suivant une dimension en épaisseur des première et deuxième couches. Selon un exemple, une portion de ces vias peut être creuse, et une autre portion peut être pleine. Ce type de vias permet de faire des largeurs de vias plus étroites pour la portion pleine, et donc plus de vias à surface donnée. Leur accessibilité est rendue plus aisée par la portion creuse déjà formée.

Selon un exemple, le substrat comprenant plusieurs ensembles de vias formant chacun un motif se répétant le long d'au moins une direction du plan d'extension principale des première et deuxième couches, au moins un ensemble, et de préférence chaque ensemble, présente au moins une configuration de via distincte d'un autre ensemble. Le substrat générique peut ainsi comprendre différentes structures de via pour s'adapter à des dispositifs microélectroniques variés.

Selon un exemple, le substrat comprend en outre un repère configuré de façon à permettre l'alignement du substrat. Cela permet de faciliter encore la fabrication du dispositif microélectronique, en facilitant l'alignement du substrat, et notamment pour la réalisation des étapes de photolithographies nécessaire à la construction du FEOL et du BEOL, et donc l'ouverture des vias.

Selon un exemple, les vias sont parallèles entre eux.

Selon un exemple, les vias présentent une dimension longitudinale orientée suivant une dimension en épaisseur de la première et de la deuxième couche.

Selon un exemple, les vias s'étendent selon une direction parallèle à la normale au plan d'extension principale des première et deuxième couches.

Selon un exemple, au moins une partie des vias, et de préférence chaque via de l'au moins un ensemble, présentent une section transversale, par exemple dans un plan sensiblement parallèle au plan d'extension principale des première et deuxième couches, de forme carrée, polygonale ou cylindrique.

Selon un exemple, la deuxième couche surmonte la première couche en étant directement à son contact.

Selon un exemple, au moins une partie des vias, et de préférence chaque via, présente une section transversale, par exemple dans un plan sensiblement parallèle au plan d'extension principale des première et deuxième couches, dont le rapport de la dimension la plus grande sur la dimension la plus petite est inférieur ou égal à 3, de préférence inférieur ou égal à 2. Les vias se distinguent donc tout à fait d'autres structures telles que des tranchées.

Selon un exemple, au moins une partie des vias, et de préférence chaque via de l'au moins un ensemble, présente une symétrie de révolution autour d'un axe sensiblement parallèle à une dimension en épaisseur des première et deuxième couches. De préférence, au moins une partie des vias, et de préférence chaque via d'au moins un ensemble, est cylindrique. Ainsi, la paroi de fond des vias est plus homogène que pour des formes non-cylindriques, par exemple une forme carrée pour laquelle les coins seront moins profonds que le centre, suite à la gravure des vias. Une forme cylindrique minimise cet effet. En outre, les contraintes mécaniques sont moins élevées pour des vias cylindriques qui n'ont pas les singularités des coins. C'est avantageux pour les traitements thermiques pendant la fabrication des circuits.

Selon un exemple, au moins un via, et de préférence chaque via d'au moins un ensemble, sur au moins une portion d'une dimension longitudinale dudit via, est intégralement entouré par une rainure s'étendant depuis la deuxième couche sur une portion de la première couche. La rainure permet d'améliorer l'isolation électrique entre les vias. La rainure est ainsi fabriquée au préalable et de façon indépendante des autres étapes de fabrication du dispositif microélectronique. La rainure est ainsi compatible avec les étapes de FEOL se déroulant à haute température. En outre, la rainure étant fabriquée au préalable, sa géométrie n'est pas limitée par les autres étapes de fabrication du dispositif microélectronique.

Selon un exemple, chaque rainure n'est pas remplie par un matériau solide. Chaque rainure est de préférence remplie d'une atmosphère gazeuse isolante électriquement, par exemple de l'air.

Selon un exemple, chaque rainure est délimitée par une paroi de fond, une paroi latérale et une paroi supérieure opposée à la paroi de fond. Pour au moins une rainure, et de préférence pour chaque rainure, au moins une partie de la paroi latérale et la paroi de fond peuvent être dans le même matériau que celui de la première couche. L'isolation des vias est en effet suffisante grâce à l'atmosphère isolante contenue dans la rainure. Alternativement, pour au moins une rainure, et de préférence pour chaque rainure, au moins une partie de la paroi latérale et la paroi de fond peuvent être en matériau diélectrique, par exemple le même matériau diélectrique que les parois du via. Ainsi, l'isolation électrique du via est encore améliorée.

Selon un exemple, la rainure est concentrique audit via. Cela permet notamment de diminuer la capacité parasite entre le via et le substrat et d'augmenter la tension de claquage.

Selon un exemple, la rainure s'étend depuis la deuxième couche dans la première couche sur une dimension longitudinale inférieure à une dimension longitudinale du via, de préférence la dimension longitudinale de la rainure est inférieure ou égale à la dimension longitudinale du via, de préférence à plus ou moins 5 µm. Ainsi, la rainure entoure le via sur au moins une portion et de préférence sensiblement toute la dimension longitudinale.

Selon un exemple, le matériau semi-conducteur est choisi parmi le groupe constitué de silicium Si, germanium Ge, SiGe, un matériau III-V (par exemple GaN, InN, InGaAs, GaP, InP, InAs, AsGa...), un matériau II-VI, des matériaux à large bande-interdite, par exemple supérieure à 3 eV.

Selon un exemple, le matériau semi-conducteur comprend, et de préférence est, du silicium.

Selon un exemple, le matériau piézoélectrique est choisi parmi le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN).

Selon un exemple, le matériau diélectrique est un oxyde de semi-conducteur, et de préférence de la silice de formule chimique SiO₂.

Selon un exemple du procédé de fabrication du substrat, la formation de la pluralité de vias est configurée de sorte qu'au moins une partie de la pluralité de vias présente au moins une configuration de via parmi celles qui suivent :
- la paroi latérale du via est faite d'un matériau diélectrique, et le via est rempli d'un matériau électriquement conducteur ou semi-conducteur ou le via est creux,
- la paroi latérale du via est faite d'un matériau diélectrique, et le via est rempli du matériau de la première couche,
- la paroi latérale du via est faite du matériau de la première couche et le via est creux.

Selon un exemple, les configurations de via diffèrent pour au moins l'une des propriétés suivantes : la nature diélectrique ou non de la paroi latérale du via ; la forme du via (et notamment la section transversale), la dimension, le matériau de remplissage du via, le caractère creux ou plein du via.

Selon un exemple, la formation de la pluralité de vias comprend, pour au moins un ensemble de vias et sur au moins une première portion desdits vias, une gravure d'au moins un pourtour du via.

Selon un exemple, la gravure est configurée de façon à graver uniquement le pourtour du via. De façon équivalente, la gravure est configurée pour graver une rainure formant le pourtour du via. Ainsi, après formation d'un oxyde dans la rainure, la paroi latérale du via est faite d'un matériau diélectrique, et le via est rempli du matériau de la première couche.

Selon un autre exemple, la gravure est configurée de façon à graver le via sur sensiblement tout son volume. Ainsi, la paroi latérale du via peut être faite du matériau de la première couche et le via peut être creux. En alternative, après formation d'un oxyde sur le pourtour de la cavité formée, la paroi latérale du via peut être faite en matériau diélectrique et le via peut être creux ou rempli.

Selon un exemple, la formation de la pluralité de vias comprend, suite à la gravure au moins du pourtour du via, une formation d'un matériau diélectrique sur au moins le pourtour gravé du via de façon à former la paroi latérale du via en matériau diélectrique.

Selon un exemple, lors de la gravure d'au moins le pourtour du via, le via est gravé sur sensiblement tout son volume, et la formation de la pluralité de vias comprend, suite à la formation d'un matériau diélectrique sur au moins le pourtour gravé du via de façon à former la paroi latérale du via en matériau diélectrique, un dépôt d'un matériau électriquement conducteur ou semi-conducteur de façon à remplir au moins en partie le via. Ainsi, la paroi latérale du via est faite du matériau diélectrique, et le via est rempli du matériau électriquement conducteur ou semi-conducteur.

On comprend donc que ces différentes étapes permettent d'aboutir aux configurations de vias précédemment décrites.

Selon un exemple, la formation de la pluralité de vias comprend la formation de plusieurs ensembles de vias formant chacun un motif se répétant le long d'au moins une direction du plan d'extension principale des première et deuxième couches,

Selon un exemple, la formation des ensembles de vias est configurée de sorte que chaque ensemble présente au moins une configuration de via distincte d'un autre ensemble.

Selon un exemple, la formation de la pluralité de vias est configurée de sorte qu'au moins un via, et de préférence au moins une partie de la pluralité de vias présente une première configuration de via sur une première portion, et une deuxième configuration de via distincte de la première configuration de via sur une deuxième portion, les première et deuxième portions s'étendant suivant une dimension en épaisseur des première et deuxième couches.

Selon un exemple, la formation d'un matériau diélectrique au niveau au moins de la paroi de fond et de la paroi latérale de la pluralité de vias comprend :
- une oxydation thermique de façon à oxyder le matériau semi-conducteur de la première couche au niveau au moins de la paroi de fond et de la paroi latérale, et/ou
- un dépôt du matériau diélectrique au niveau au moins de la paroi de fond et de la paroi latérale.

Ces techniques, et tout particulièrement l'oxydation thermique, permettent d'obtenir une bonne conformité des parois en matériau diélectrique. L'oxydation thermique étant conforme, elle permet d'obtenir un oxyde à la fois dense et d'épaisseur uniforme sur les parois de fond et latérales. L'oxydation thermique est donc particulièrement avantageuse en synergie avec des hauts facteurs de forme des vias. Par rapport à un dépôt, l'oxydation thermique permet en outre un lissage de la paroi des vias gravée et limite la présence de défauts entre le matériau semi-conducteur de la première couche et le diélectrique.

Selon un exemple, lorsque la paroi latérale est en matériau diélectrique, la paroi latérale de la pluralité de vias présente une dimension transverse sensiblement comprise entre 50 nm et 600 nm, de préférence sensiblement égale à 400 nm.

Selon un exemple, lorsque la paroi de fond, est en matériau diélectrique, la paroi présente une dimension longitudinale sensiblement comprise entre 50 nm et 600 nm, de préférence sensiblement égale à 400 nm.

Selon un exemple, la couche superficielle du sous-substrat donneur est une couche à base, et de préférence faite, d'un matériau choisi parmi un matériau diélectrique, par exemple un oxyde, un matériau semi-conducteur ou un matériau piézoélectrique.

Selon un exemple :
- le sous-substrat support comprend en outre une couche superficielle à base, et de préférence faite, d'un matériau diélectrique, par exemple un oxyde, surmontant la première couche, la couche superficielle présentant la surface exposée, et/ou
- la couche superficielle du sous-substrat donneur est une couche à base, et de préférence faite, d'un matériau diélectrique, par exemple un oxyde, surmontant une couche à base d'un matériau choisi parmi un matériau semi-conducteur ou un matériau piézoélectrique.

On comprend donc que la couche d'oxyde enterrée du substrat peut provenir du sous-substrat donneur et/ou du sous-substrat support.

Selon un exemple, la couche superficielle du substrat donneur est à base, de préférence faite, de l'un parmi un matériau semi-conducteur ou un matériau diélectrique. Selon que la couche superficielle est à base d'un matériau semi-conducteur ou d'un matériau diélectrique, on comprend que la paroi supérieure des vias, et le cas échéant des rainures, est à base ou faite d'un matériau semi-conducteur ou d'un matériau diélectrique.

Selon un exemple, le procédé de fabrication du substrat comprend en outre, préalablement à l'assemblage du sous-substrat support et du sous-substrat donneur, une gravure d'une rainure entourant intégralement au moins un via sur au moins une portion d'une dimension longitudinale dudit via, la rainure s'étendant depuis la couche superficielle dans la première couche. Les effets et avantages décrits relativement à la rainure sont donc obtenus.

Selon un exemple, le procédé comprend une formation d'une zone de fragilisation à une profondeur de la surface de la couche superficielle du substrat donneur, puis une séparation du substrat donneur au niveau de la zone de fragilisation.

Selon un exemple, le procédé de fabrication du dispositif microélectronique comprend, une sélection d'au moins un via à graver parmi la pluralité de vias, uniquement une partie de la pluralité de vias étant sélectionné comme via à graver. Ainsi, il est possible de sélectionner les vias à graver parmi les vias présents dans le substrat. Le procédé est ainsi adaptable selon la configuration de dispositif microélectronique désirée, pour différents dispositifs microélectroniques. Cette sélection peut être faite préalablement à une gravure par l'une parmi les surfaces exposées avant ou arrière du substrat.

Selon un exemple, la sélection de l'au moins un via à graver comprend l'application, sur ladite surface exposée avant ou arrière du substrat, d'un masque comprenant des ouvertures situées à l'aplomb de l'au moins un via à graver, suivie de la gravure de façon à atteindre l'au moins un via à graver. Ainsi, on évite une potentielle fragilisation de la paroi des vias à graver, par rapport à un amincissement étendu de la face du substrat. Cette gravure grave ainsi la couche au droit de l'au moins un via à graver jusqu'à déboucher dans l'au moins un via à graver.

Selon un exemple, lorsque le procédé met en œuvre la gravure par l'autre parmi les surfaces exposées avant ou arrière du substrat, jusqu'à atteindre le via, la sélection de l'au moins un via à graver parmi la pluralité de vias comprend l'application, sur ladite autre surface exposée avant ou arrière du substrat, d'un masque comprenant des ouvertures situées à l'aplomb de l'au moins un via à graver, et le procédé comprend en outre une gravure de façon à atteindre l'au moins un via à graver. Ceci est particulièrement avantageux lorsque le via est rempli par un matériau électriquement conducteur ou semi-conducteur, y compris le matériau de la première couche. Cela permet d'atteindre le via par les faces arrière et avant du substrat, pour mettre en continuité électrique le via.

Selon un exemple, le dépôt de l'organe électriquement conducteur ou semi-conducteur est configuré de façon à en outre recouvrir par une couche électriquement conductrice ou semi-conductrice au moins une portion de la surface exposée avant et/ou arrière du substrat.

Selon un exemple, le procédé comprend une réalisation de motifs dans la couche électriquement conductrice ou semi-conductrice arrière.

Selon un exemple, le procédé comprend la passivation de la surface exposée arrière du substrat.

Selon un exemple, le procédé de fabrication d'un dispositif microélectronique comprend :
- entre la formation de l'au moins une portion de couche du dispositif, et la gravure par la surface exposée arrière du substrat, le montage d'un support sur la surface exposée avant du substrat, et
- après le dépôt de l'organe électriquement conducteur ou semi-conducteur de façon à remplir la cavité électrique, le démontage du support.

Le support permet ainsi de faciliter la manipulation du substrat.

Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques, ainsi que des dispositifs optiques ou optoélectroniques. Il peut s'agir d'un dispositif destiné à assurer une fonction électronique, optique, mécanique etc. Il peut aussi s'agir **d'un produit** intermédiaire uniquement destiné à la réalisation d'un autre dispositif microélectronique. Il peut aussi s'agir d'une structure d'interconnexions électriques passives.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Une couche peut par ailleurs être composée de plusieurs sous-couches d'un même matériau ou de matériaux différents.

On entend par un élément « à base » d'un matériau A, un élément comprenant ce matériau A uniquement ou ce matériau A et éventuellement d'autres matériaux.

Dans la description détaillée qui suit, il pourra être fait usage de termes tels que « longitudinal », « transversal ». Ces termes doivent être interprétés relativement au substrat ou à la dimension en épaisseur des dispositifs. Ainsi, une dimension longitudinale, une hauteur, une profondeur ou une épaisseur d'un élément ou d'une couche s'entend d'une dimension selon l'épaisseur du substrat qui le porte ou le contient. Une largeur, ou encore une section ou une dimension transversale s'entend d'une dimension perpendiculaire à l'épaisseur du substrat.

Certaines parties du substrat ou du dispositif de l'invention peuvent avoir une fonction électrique. Certaines sont employées pour des propriétés de conduction électrique et on entend par électriquement conducteurs ou équivalents, des éléments formés d'au moins un matériau ayant une conductivité suffisante, dans l'application, pour réaliser la fonction souhaitée. D'autres parties, au contraire, sont employées pour des propriétés d'isolation électrique et tous matériaux ayant une résistivité suffisante pour réaliser cette isolation sont concernés et sont notamment appelés diélectriques ou électriquement isolants.

Le mot « diélectrique » qualifie plus particulièrement un matériau dont la conductivité électrique est suffisamment faible dans l'application donnée pour servir d'isolant. Dans la présente invention, un matériau diélectrique présente de préférence une constante diélectrique inférieure à 4.

On entend par « collage direct » un collage sans apport de matière adhésive (de type colle ou polymère notamment) qui consiste en la mise en contact de surfaces relativement lisses (d'une rugosité moyenne quadratique RMS, de l'anglais Root Mean Square, typiquement inférieure à 5 Å, 10⁻¹⁰ m), par exemple réalisé à température ambiante et sous atmosphère ambiante, afin de créer une adhérence entre elles.

Selon un mode de réalisation, le collage direct de deux substrats signifie que le collage est obtenu par les liens chimiques qui s'établissent entre les deux surfaces mises en contact. Ces liens chimiques peuvent être par exemple des liaisons de Van der Waals et/ou des liaisons chimiques fortes, covalentes, notamment lorsque le collage est assisté par une activation plasma ou suivi d'un traitement thermique de renforcement (typiquement 200 à 1200°C pendant 1h).

Le collage direct peut être obtenu sans nécessiter l'application d'une pression importante sur la structure à assembler. Une légère pression pourra simplement être appliquée pour initier le collage. Un recuit thermique peut en outre être effectué pour renforcer le collage.

On entend par un paramètre « sensiblement égal/supérieur/inférieur à » une valeur donnée, que ce paramètre est égal/supérieur/inférieur à la valeur donnée, à plus ou moins 10% près, voire à plus ou moins 5% près, de cette valeur.

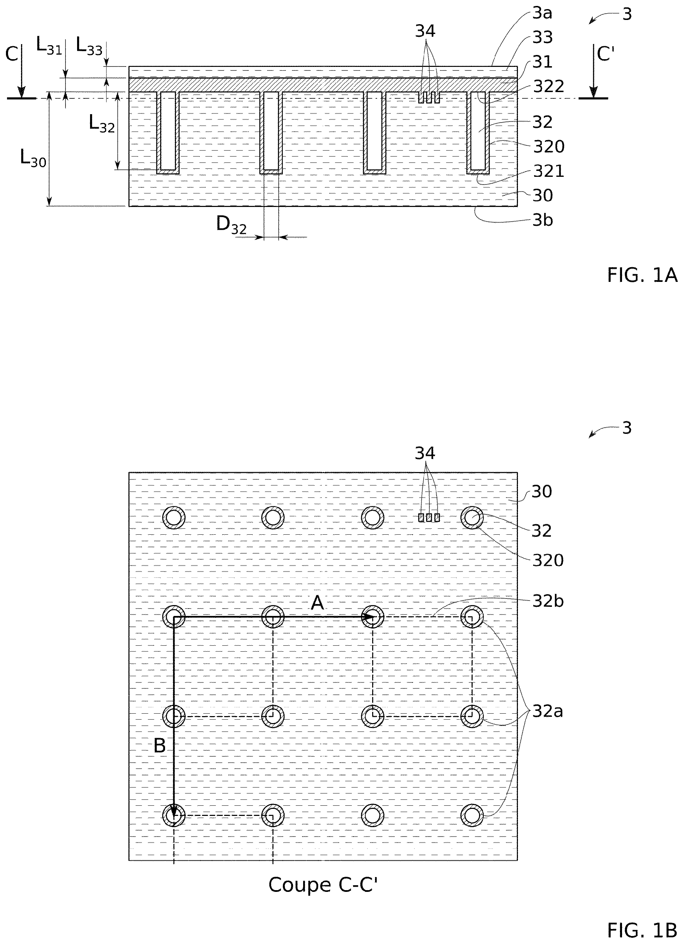

Le substrat 3 est maintenant décrit selon plusieurs exemples de réalisation en référence aux figures 1A à 2C.

Comme par exemple illustré par la figure 1A, le substrat 3 comprend une première couche 30, à base ou faite d'un matériau semi-conducteur. Selon un exemple le matériau semi-conducteur comprend, et de préférence est, du silicium. Notons que comme décrit ultérieurement, d'autres matériaux semi-conducteurs sont envisageables. La première couche 30 présente une épaisseur L₃₀, par exemple sensiblement comprise entre 100 µm et 800 µm.

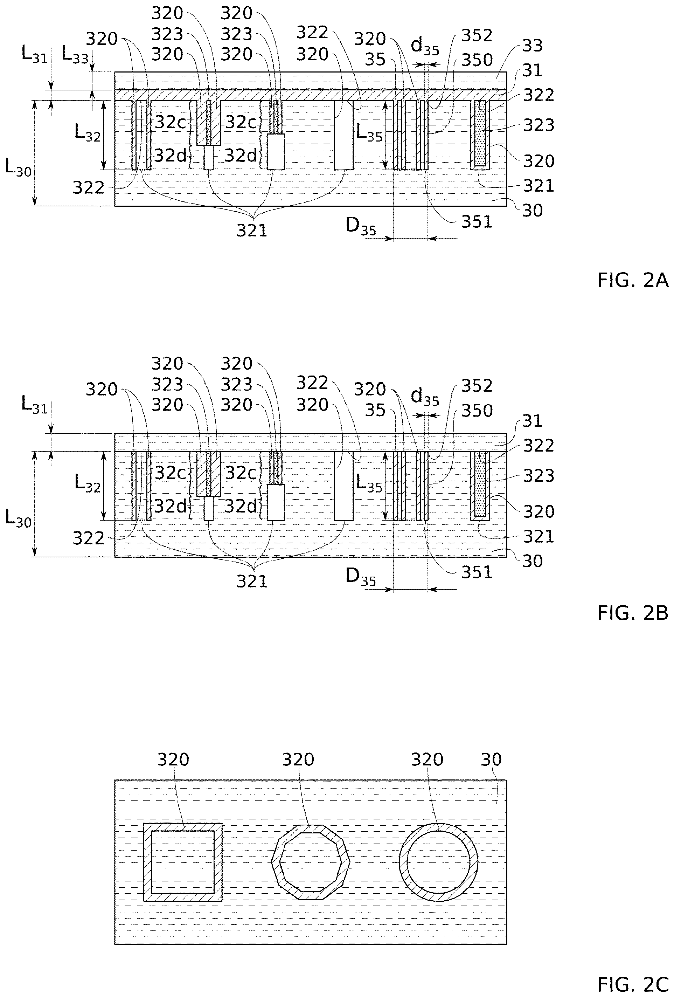

Le substrat 3 comprend en outre une deuxième couche 31. Comme illustré par les figures 1A et 2A, la deuxième couche 31 peut être à base ou faite d'un matériau diélectrique. Selon un exemple le matériau diélectrique comprend, et de préférence est, un oxyde de semi-conducteur, par exemple de la silice de formule SiO₂. La deuxième couche 31 surmonte la première couche 30, de préférence en étant directement à son contact. Comme illustré par la figure 2B, la deuxième couche 31 peut en alternative être à base ou faite d'un matériau semi-conducteur, de préférence monocristallin, ou d'un matériau piézoélectrique. La deuxième couche 31 peut présenter une épaisseur L₃₁, par exemple supérieure ou égale à 10 nm, préférentiellement à 100 nm. L'épaisseur L₃₁ peut être inférieure ou égale à 3000 nm. La deuxième couche 31 du substrat 3 est de préférence exempte de portions métalliques. La deuxième couche 31 est de préférence continue dans le plan d'extension principale du substrat 3.

Selon un exemple, pouvant être illustré par les figures 1A et 2A, la deuxième couche 31 est surmontée d'une troisième couche 33 à base ou faite d'un matériau semi-conducteur, de préférence monocristallin, ou d'un matériau piézoélectrique. Selon un exemple le matériau semi-conducteur comprend, et de préférence est, du silicium. Notons ici encore que comme décrit ultérieurement, d'autres matériaux semi-conducteurs sont envisageables. La troisième couche 33 présente une épaisseur L₃₃, par exemple sensiblement comprise entre 10 nm et 20 000 nm. Le substrat 3 peut donc comprendre une structure de type semi-conducteur sur isolant, et notamment de type silicium-sur-isolant (SOI). Notons qu'on peut prévoir que la deuxième couche 31 ne soit pas surmontée d'une troisième couche semi-conductrice. La troisième couche 33 du substrat 3 est de préférence exempte de portions métalliques. La troisième couche 33 est de préférence continue dans le plan d'extension principale du substrat 3.

Selon un exemple, le matériau à base duquel une couche 30, 31, 33 est formée est de préférence continu dans le plan d'extension de la couche. Au moins une et de préférence chaque couche(s) 30, 31 33 est de préférence continue sur au moins 80 %, de préférence sur au moins 90 %, et plus préférentiellement encore la totalité, du plan d'extension principale du substrat 3.

La première couche 30 et/ou la deuxième couche 31 est/sont de préférence monolithique(s). La première couche 30 est de préférence monolithique sur au moins la portion sur laquelle s'étendent les vias 32.

Dans la suite, sauf mention explicite du contraire, on considère à titre non-limitatif que le substrat 3 est un substrat SOI, la première couche 30 étant en silicium monocristallin, la deuxième couche en SiO₂ et la troisième couche en silicium monocristallin.

Le substrat 3 comprend des vias 32 s'étendant depuis la deuxième couche 31 dans la première couche 30. Les vias 32 s'étendent de préférence sur une dimension longitudinale L₃₂ orientée dans le sens de l'épaisseur des première 30 et deuxième 31 couches. Les vias 32 peuvent être parallèles entre eux. Les vias 32 sont enterrés dans le substrat 3, c'est-à-dire qu'ils ne débouchent pas sur l'une ou l'autre des surfaces exposées 3a, 3b du substrat 3. Les vias 32 définissent donc un volume clos.

Ainsi, le substrat 3 comprend des vias 32 pour leur utilisation ultérieure dans un procédé de fabrication d'un dispositif microélectronique. Ceci permet de fournir les vias indépendamment des autres étapes de réalisation d'un dispositif microélectronique 4, comme décrit ultérieurement en référence au procédé de fabrication du dispositif microélectronique.

La dimension longitudinale L₃₂ peut être choisie de sorte que les vias 32 affleurent la surface de la première couche 30, à l'interface avec la deuxième couche 31, comme par exemple illustré dans les figures 1A à, 2A et 2C. En variante, non illustrée ici, les vias 32 peuvent en outre s'étendre sur une portion de l'épaisseur L₃₁ de la deuxième couche 31. C'est le cas par exemple lorsque le sous-substrat donneur 2 et le sous-substrat support 1 présentent chacun une couche superficielle à base d'un matériau diélectrique, ces couches superficielles formant ensemble la deuxième couche 31 après l'assemblage.

Les vias 32 étant non débouchants, ils sont délimités par une paroi latérale 320, une paroi de fond 321 et une paroi supérieure 322 opposée à la paroi de fond 321. Notons qu'on peut définir de façon interchangeable la surface avant 3a et la surface arrière 3b du substrat 3 par rapport aux parois de fond 321 et supérieure 322 des vias. Dans la suite et y compris pour le procédé de fabrication du dispositif microélectronique décrit ultérieurement, on considère à titre non limitatif que la paroi de fond 321 est disposée vers la surface arrière 3b du substrat 3 et la paroi supérieure 322 est disposée vers la surface avant 3a du substrat 3. Les procédés décrits ultérieurement peuvent toutefois être adaptés au cas où la paroi de fond 321 est disposée vers la surface avant 3a du substrat 3 et la paroi supérieure 322 est disposée vers la surface arrière 3b du substrat 3.

L'une et/ou l'autre des surfaces exposées sur substrat 3 peuvent être à base d'un matériau semi-conducteur, de préférence monocristallin. Les vias 32 peuvent être surmontés d'une couche ou d'un empilement de couches comprenant au moins une couche à base d'un matériau semi-conducteur, de préférence monocristallin. On comprend donc que la deuxième couche 31 et/ou la deuxième couche 33 peuvent être à base d'un matériau semi-conducteur, de préférence monocristallin, comme décrit précédemment. Ainsi, le substrat générique 3 comprenant les vias est compatible avec les étapes du FEOL et du BEOL.

Par exemple, la sélection des vias à graver 32' peut être faite par la face avant, et par exemple après une gravure du substrat 3 des vias 32 en face arrière. La sélection des vias à graver 32' peut être faite par la face arrière, et par exemple avant ou après une gravure du substrat 3 des vias 32 en face avant.

Selon un exemple pouvant être illustré par les figures 1A et 1B, les vias 32 forment au moins un ensemble 32a comprenant un motif 32b se répétant au moins une fois le long d'au moins une direction, de préférence de deux directions, du plan d'extension principale des première 30 et deuxième 31 couches. Ces directions sont de préférence perpendiculaires. On peut prévoir que ces directions ne soient pas perpendiculaires entre elles. On a donc au moins un motif 32b de vias 32 et un ou plusieurs ensembles 32a de vias 32 répétant un motif 32b. Chaque ensemble comprend un motif 32b répété de via 32. Les motifs 32b peuvent être différents entre plusieurs ensembles 32a.

Un motif 32b peut ne comprendre qu'un seul via 32, ou plusieurs vias 32 comme illustré en figure 1B. Le motif 32b de via peut être de toute forme. Selon un exemple, plusieurs vias 32 peuvent former un motif polygonal pris dans un plan parallèle au plan d'extension principale des première 30 et deuxième 31 couches. Les motifs 32b de vias 32 peuvent être disposés à intervalles réguliers dans le plan d'extension principale des première 30 et deuxième 31 couches.

Ainsi, le substrat 3 peut être un substrat générique comprenant une matrice de vias, dans laquelle des vias à graver 32 seront choisis en fonction des organes électriquement conducteur ou semi-conducteur à former, comme décrit plus en détail ultérieurement.

Pour cela, les motifs 32b de vias 32 peuvent être successivement séparés par un premier pas A selon une première direction contenue dans le plan d'extension principale des première 30 et deuxième 31 couches. Les motifs 32b de vias 32 peuvent être successivement séparés par un deuxième pas B selon une deuxième direction contenue dans le plan d'extension principale des première 30 et deuxième 31 couches, distincte de la première. De préférence, ces première et deuxième directions sont perpendiculaires. Ces pas sont pris centre à centre entre un via du motif 32b et le via correspondant du motif 32b suivant, comme l'illustre la figure 1B. Les pas A et/ou B sont de préférence constants, c'est à dire sensiblement identiques pour chaque répétition de motifs.

L'un et/ou l'autre de ces pas A et B peuvent être sensiblement compris entre 50 µm et 300 µm, de préférence entre 100 µm et 200 µm. Ces pas peuvent être différents l'un de l'autre ou égaux entre eux, selon la géométrie de matrice désirée.

Selon un exemple préférentiel, le substrat 3 comprend un unique motif 32b de via 32, comprenant de préférence un seul via 32. Selon cet exemple, chaque via 32 est séparé du ou des vias 32 voisins par des pas A et B sensiblement identiques pour chaque répétition de motifs. Les pas A et B sont de préférence égaux entre eux.

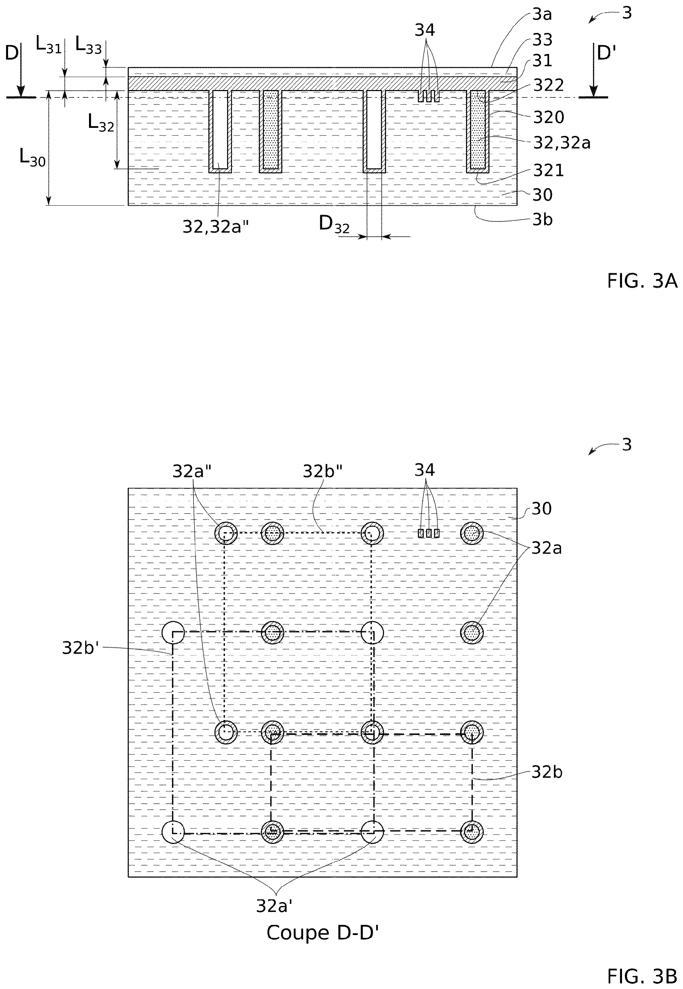

Selon un exemple illustré par les figures 3A et 3B, les vias 32 forment plusieurs ensembles 32a, 32a', 32a", c'est-à-dire au moins deux ensembles ou plus. Chaque ensemble 32a, 32a', 32a" peut comprendre un motif 32b de via se répétant comme décrit ci-dessus. Les motifs 32b, 32b', 32b" de différents ensembles peuvent être différents, comme l'illustre par exemple la figure 3B.

Le ou les motif(s) 32b peut se répéter le long d'une direction, de préférence des deux directions distinctes ci-dessus, du plan d'extension principale des première 30 et deuxième 31 couches, sur au moins 80 % de la dimension du substrat 3 selon cette/ces direction(s). Le ou les motif(s) 32b de vias 32 se répètent de préférence, dans le plan d'extension principale de la première couche 30, sur au moins 80 %, de préférence au moins 90 %, et plus préférentiellement encore au moins 95 %, du plan d'extension principale de la première couche 30. Le ou les motif 32b de vias 32 se répètent en outre de préférence, dans le plan d'extension principale du substrat 3, sur au moins 80 %, de préférence au moins 90 %, et plus préférentiellement encore au moins 95 %, du plan d'extension principale du substrat 3. Le substrat générique 3 comprend ainsi une ou des matrices de vias 32 génériques sur une grande partie de sa surface, pour faciliter la fabrication d'un dispositif microélectronique comme décrit en détail ultérieurement. Ces vias 32 pourront notamment être sélectionnés en fonction de l'architecture désirée, avec un substrat générique 3 qui puisse être adapté à la fabrication de différents dispositifs microélectroniques.

Selon un exemple, au moins une partie des vias 32 et de préférence chaque via, s'étend sur une hauteur supérieure ou égale à 50 % de l'épaisseur du substrat 3, de préférence supérieure ou égale à 70 % de l'épaisseur du substrat 3.

Les vias 32 peuvent par ailleurs présenter une configuration parmi plusieurs configurations, ou de façon équivalente une structure parmi plusieurs structures. Par exemple, les vias 32 peuvent être au moins en partie creux et/ou au moins en partie remplis d'un matériau solide. Ces configurations sont maintenant décrites en références aux figures 2A à 2C, qui illustrent différentes configurations possibles de vias. Les motifs 32b de vias répétés ne sont pas représentés.

Selon un exemple, la paroi latérale 320 du via 32 peut être faite d'un matériau diélectrique, et le via 32 peut être rempli d'un matériau électriquement conducteur 323 ou semi-conducteur. Cette configuration est compatible avec les étapes du FEOL.

La paroi latérale 320 du via 32 peut être faite d'un matériau diélectrique et le via 32 peut être creux. De préférence, selon ces exemples, au moins la paroi latérale 320 et la paroi de fond 321 sont en matériau diélectrique. La paroi supérieure 320 peut être en matériau diélectrique ou en matériau semi-conducteur ou en matériau piézoélectrique, comme il apparaitra plus clairement lors de la description du procédé de fabrication du substrat 3.

Selon un autre exemple, la paroi latérale 320 du via 32 peut être faite d'un matériau diélectrique, et le via 32 est rempli du matériau de la première couche 30. Selon cet exemple, la paroi de fond 321 du via peut se situer à la normale de la paroi latérale 320 à son extrémité. Cette paroi de fond peut ne pas être matérialisée physiquement par un changement de matériau, comme l'illustre les pointillés en figure 2A.

Selon un autre exemple, le via 32 peut être creux et non délimité par une paroi latérale en matériau diélectrique. La paroi latérale 320 du via 32 peut être faite du matériau de la première couche 30.

Lorsque le via 32 est creux, il n'est pas rempli d'un matériau solide. Le via 32 est de préférence remplis d'une atmosphère gazeuse telle que de l'air, de l'azote ou de l'argon, éventuellement à une pression inférieure ou égale à la pression ambiante.

Lorsqu'au moins la paroi de fond 321 et la paroi latérale 320 sont en matériau diélectrique, le via 32 une fois rempli par un matériau conducteur électriquement ou semi-conducteur sera isolé électriquement de la première couche 30 et des autres vias 32. En variante, les parois des vias 32, et notamment la paroi latérale 320, peuvent être en matériau semi-conducteur, et plus particulièrement du même matériau que celui de la première couche 30. L'isolation électrique des vias 32 peut être faite ultérieurement lors du procédé de fabrication du dispositif microélectronique à partir du substrat 3, décrit ultérieurement.

Les vias peuvent présenter une dimension transversale D₃₂, par exemple un diamètre, sensiblement inférieure ou égale à 30 µm, de préférence sensiblement comprise entre 1 µm et 30 µm, de préférence sensiblement comprise entre 5 µm et 15 µm, et plus préférentiellement encore entre 8 et 12 µm. Ainsi, la dimension latérale D₃₂ est inférieure aux dimensions typiques des TSV-last, ce qui permet d'avoir un plus grand nombre de vias 32 pour une même surface du substrat 3 dans le plan d'extension principale des première 30 et deuxième 31 couches, c'est-à-dire une plus grande densité de vias 32. La dimension longitudinale des vias L₃₂ peut être de l'ordre de l'épaisseur L₃₀ de la couche 30, les vias 32 étant non débouchants. L₃₂ peut être sensiblement inférieure ou égale à 200 µm, de préférence sensiblement comprise entre 50 et 150 µm, par exemple sensiblement égale à 100 µm. Ces gammes de longueur permettent de faciliter la formation d'un organe électriquement conducteur ou semi-conducteur traversant, par exemple une interconnexion traversante par le via 32, du substrat 3 lors de la fabrication du dispositif microélectronique 4.

Un via 32 peut en outre présenter plusieurs portions présentant chacune une configuration, les configurations étant différentes entre les portions. Par exemple, un via peut présenter une première portion 32c avec une configuration, et une deuxième portion 32d avec une configuration différente, comme illustré par exemple dans les figures 2A et 2B. La dimension latérale D₃₂ d'un via peut être différente entre les portions, par exemple la première portion 32c et la deuxième portion 32d. Notamment, une première portion peut être remplie et une deuxième portion peut être creuse. Cela permet d'obtenir un via de dimension plus petite tout en facilitant l'accès par la portion creuse.

Les vias 32 peuvent présenter un facteur de forme sensiblement supérieur ou égal à 5, et de préférence supérieur ou égal à 10. Par facteur de forme, on entend le rapport entre la dimension la plus longue sur la dimension la plus courte. Ici le facteur de forme F est tel que F = L₃₂/D₃₂. Ce facteur de forme permet de faciliter la formation d'un organe électriquement conducteur ou semi-conducteur traversant, par exemple une interconnexion traversante par le via 32, lors de la fabrication du dispositif, et d'augmenter la densité des vias 32 sur le substrat.

Comme illustré en figure 2C, un via peut présenter une section transversale, par exemple dans un plan sensiblement parallèle au plan d'extension principale des première 30 et deuxième 31 couches, de forme carré, polygonale, ou cylindrique. De préférence, les vias 32 sont cylindriques.

Selon un exemple illustré en figure 2A et 2B, un via 32 peut comprendre une rainure 35 configurée pour améliorer l'isolation électrique des vias 32. Le substrat 32 est ainsi particulièrement adapté pour des applications de hautes fréquences et/ou en remplacement de substrat de haute résistivité pour les applications le demandant. Pour cela, le via 32 présente une section transversale intégralement entourée de la rainure 35, prise dans le plan d'extension principale des première 30 et deuxième 31 couches. La rainure 35 peut entourer le via 32 sur au moins une portion de sa dimension longitudinale L₃₂. Les rainures 35 sont de préférence disposées de façon à isoler les vias 32 les uns des autres, une rainure 35 entourant de préférence un seul via 32. Les rainures 35 ne se touchent de préférence pas entre elles. La rainure 35 peut plus particulièrement s'étendre depuis la deuxième couche 31 sur une portion de la première couche 30. Notons que la rainure 35 peut être disposée autour d'un via 32 quelle que soit sa configuration décrite ci-dessus. La rainure confère une meilleure isolation diélectrique à la configuration de via qu'elle entoure.

Chaque rainure 35 est de préférence enterrée, c'est-à-dire qu'elle ne débouche pas sur l'une ou l'autre des surfaces exposées 3a, 3b du substrat 3. Chaque rainure 35 définit donc un volume clos. Chaque rainure 35 peut être creuse, elle n'est pas remplie d'un matériau solide. Chaque rainure 35 est alors de préférence remplie d'une atmosphère gazeuse telle que de l'air, de l'azote ou de l'argon, éventuellement à une pression inférieure ou égale à la pression ambiante. Chaque rainure 35 peut être remplie, de préférence entièrement, d'un matériau solide, et par exemple d'un matériau diélectrique.

Chaque rainure 35 peut être délimitée par une paroi latérale 350, une paroi de fond 351 et une paroi supérieure 352 opposée à la paroi de fond 351. La paroi de fond 351 est disposée vers la surface arrière 3b du substrat et la paroi supérieure 352 est disposée vers la surface avant 3a du substrat 3. Parmi ces parois, au moins la paroi de fond 351 et la paroi latérale 350 peuvent être en matériau diélectrique, par exemple en SiO₂. Comme l'illustre la figure 2A, toutes les parois peuvent être en matériau diélectrique. On peut prévoir que la rainure 35 affleure la surface de la première couche 30, comme les vias 32 illustrés en figure 2A et 2B. La paroi supérieure 352 peut être du même matériau que la deuxième couche 31. Toutes les parois peuvent être dans le même matériau que la couche dans laquelle ou contre laquelle elles s'étendent, en matériau diélectrique, semi-conducteur ou piézoélectrique selon la couche considérée.

Comme illustré par exemple par les figures 2A et 2B, chaque rainure 35 peut présenter une dimension longitudinale, ou de façon équivalente une profondeur, L₃₅ sensiblement égale ou inférieure à celle du via L₃₂, selon un exemple égale à plus ou moins 5 µm.

Comme illustré par exemple par les figures 2A et 2B, chaque rainure 35 peut présenter une dimension transversale D₃₅ prise de part et d'autre du via 32, par exemple un diamètre, sensiblement inférieure ou égale à 50 µm, de préférence sensiblement comprise entre 20 µm et 30 µm. Chaque rainure 35 peut présenter une largeur sensiblement inférieure ou égale à 5 µm, par exemple sensiblement comprise entre 2 et 4 µm. Ainsi, de façon similaire aux dimensions des vias 32, une amélioration de l'isolation électrique peut être obtenue tout en permettant d'obtenir une grande densité de vias 32. Synergiquement, il est particulièrement avantageux d'utiliser ces rainures 35 lorsque les vias 32 sont proches les uns des autres, comme c'est le cas pour une haute densité de vias 32 sur le substrat 3, afin d'améliorer leur isolation électrique. Par haute densité, par exemple les pas A et/ou B sont inférieurs ou égaux à 100 µm. On peut prévoir que les rainures 35 présentent des dimensions égales ou distinctes entre les différentes rainures 35.

Selon les dimensions des rainures 35 dans le plan d'extension principale des première 30 et deuxième 31 couches, le pas peut être adapté de sorte que les rainures 35 sont distinctes les unes des autres. Chaque rainure 35 peut être cylindrique, et de préférence concentrique au via 32 qu'elle entoure.

Lorsque le substrat 3 comprend plusieurs ensembles 32a, chaque ensemble peut présenter une configuration de via, ou le cas échant plusieurs tronçons de configurations. Les configurations de via 32 de différents ensembles 32a peuvent différer entre elles. De préférence, chaque via 32 d'un même ensemble 32a présente la même configuration de via, ou le cas échant plusieurs tronçons de configurations. Les dimensions des vias 32 peuvent en outre varier entre les différents ensembles 32a. De préférence, chaque via 32 d'un même ensemble 32a présente les mêmes dimensions. La section transversale des vias 32 peut en outre varier entre les différents ensembles 32a. De préférence, chaque via 32 d'un même ensemble 32a présente la même section transversale.

Comme l'illustrent par exemple les figures 1A, 1B, et 3A, 3B, le substrat 3 peut comprendre au moins une marque ou de façon équivalente un repère 34 permettant l'alignement du substrat 3 avec d'autres éléments. Ainsi, le placement des vias 32 lors du procédé de fabrication du dispositif microélectronique est fiabilisé. Ce repère 34 peut être formé par une ou plusieurs portion(s) de couche de matériau diélectrique au niveau de la première couche 30 et/ou de la deuxième couche 31. Notons que la personne du métier peut tout à fait envisager d'autres variantes de repère, comme par exemple un marquage disposé sur la surface 3a avant ou la surface arrière 3b du substrat 3.

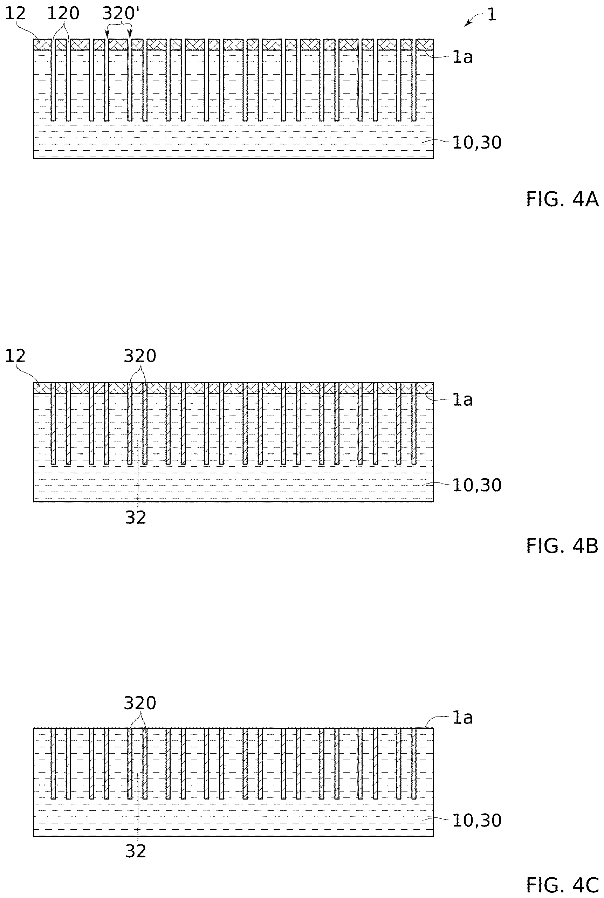

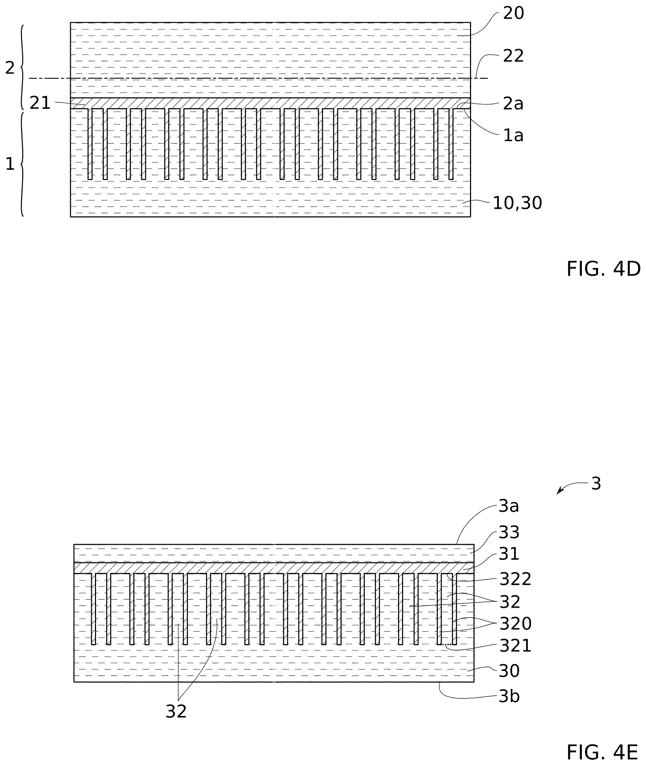

Le procédé de fabrication du substrat 3 est maintenant décrit en référence aux figures 4A à 5D.

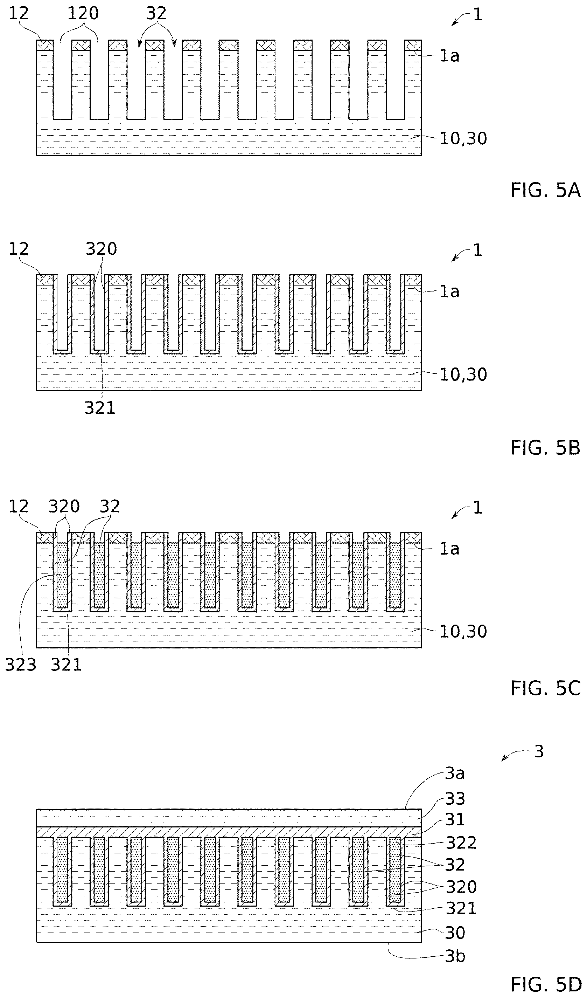

Le procédé comprend la fourniture d'un sous-substrat 1. Le sous-substrat 1 comprend au moins une première couche 10, destinée à former la première couche 30 du substrat 3 qui sera obtenu, comme l'illustre par exemple les figures 4A et 5A. Selon un exemple non illustré, le sous-substrat 1 peut comprendre en outre une couche superficielle destinée à former au moins en partie la deuxième couche 31 du substrat 3. La couche superficielle est de préférence à base ou faite d'un matériau diélectrique. Le sous-substrat 1 présente en outre une surface exposée 1a, au niveau de la première couche 10 ou de la couche superficielle 11.

Comme par exemple illustré par les figures 4A et 5A, les vias 32 peuvent être formés par gravure, et de préférence par gravure ionique réactive profonde (communément abrégée DRIE, de l'anglais « *Deep Reactive lon Etching* »)*.* Pour cela, l'étape de gravure peut comprendre l'application d'un masque 12 comprenant des ouvertures 120 à partir desquelles les vias 32 vont être gravés, comme l'illustre par exemple la figure 5A. Le masque 12 est de préférence un masque en résine. On peut prévoir que le masque soit dur, par exemple avec l'application d'un masque 12 en résine puis la gravure de la couche superficielle 11 en matériau diélectrique, retirer ce masque et graver la première couche 10 grâce au masque d'oxyde dit « dur » ainsi formé. Notons que la couche superficielle 11 peut être retirée après la gravure des vias 32, et les vias 32 isolés électriquement par dépôt d'une couche diélectrique par la suite.

La gravure est de préférence configurée pour obtenir les caractéristiques des vias 32 décrites précédemment, et notamment leurs dimensions et les pas les séparant. Par exemple, les dimensions du masque 12 et/ou le temps et la vitesse de gravure sont ajustés pour cela.

La gravure est configurée pour graver uniquement le pourtour des vias 32. Comme l'illustre par exemple la figure 4A, une rainure 320' peut être gravée, cette rainure 320' étant destinée à former la paroi latérale 320 du via 32. En variante, comme l'illustre par exemple la figure 5A, le via 32 peut être gravé sur sensiblement tout son volume.

Pour former la paroi latérale 320 en matériau diélectrique, le procédé peut ensuite comprendre une formation d'un matériau diélectrique pour former la paroi latérale 320. Comme l'illustre par exemple la figure 4B, la rainure 320' peut être remplie, de préférence entièrement, par un matériau diélectrique. Pour cela, le matériau diélectrique, par exemple de la silice SiO₂, peut être déposé. Ce dépôt peut être un dépôt chimique en phase vapeur (communément abrégé CVD, de l'anglais *Chemical Vapor Deposition*) à partir de précurseurs gazeux comprenant de l'oxygène et du silicium, par exemple de l'orthosilicate de tétraéthyle (communément abrégé TEOS de l'anglais *tetraethyl orthosilicate*) ou du silane de formule chimique SiH₄, éventuellement combiné avec du dioxygène. Le dépôt est par exemple un dépôt CVD à pression subatmosphérique (communément abrégé SACVD, de l'anglais *Sub-Atmospheric CVD*), ou un dépôt en phase chimique assisté par plasma (communément abrégé PECVD, de l'anglais Plasma-Enhanced CVD.

Lorsque le via 32 est gravé sur sensiblement tout son volume, la formation du matériau diélectrique peut être réalisée sur la paroi latérale 320 et la paroi de fond 321, comme l'illustre par exemple la figure 5B. Cette formation peut être faite par dépôt du matériau diélectrique comme décrit ci-dessus. Cette formation peut en variante être faite par oxydation thermique, par exemple à une température de sensiblement 1050 °C dans une atmosphère comprenant de l'oxygène.

De préférence, la formation des parois 320, 321 est configurée de sorte que les parois 320, 321 en matériau diélectrique présentent une dimension sensiblement comprise entre 50 nm et 600 nm, et de préférence sensiblement égale à 400 nm. Pour la paroi latérale 320, cette dimension est la dimension transversale. Pour la paroi de fond 321, cette dimension est la dimension longitudinale. Par exemple, le temps d'oxydation thermique ou le temps de dépôt et/ou la vitesse de dépôt peuvent être ajustés pour cela.

Lorsque le via 32 est gravé sur sensiblement tout son volume, et de préférence suite à la formation des parois 320, 321 en matériau diélectrique, le via 32 peut être rempli par un matériau 323 électriquement conducteur ou semi-conducteur, comme par exemple illustré en figure 5C. Le matériau conducteur peut être un métal, par exemple du cuivre ou du tungstène. Le matériau semi-conducteur peut être du silicium polycristallin (généralement désigné Poly-Si). Ce remplissage est de préférence fait par dépôt du matériau 323 dans le via 32. Par exemple, le dépôt de Poly-Si est généralement fait par LPCVD (abrégé de l'anglais *Low Pressure Chemical Vapor Deposition,* que l'on peut traduire par dépôt chimique en phase vapeur à pression sous-atmosphérique).

Selon les étapes de formations des vias décrites ci-dessus, les différentes configurations des vias 32 décrites précédemment peuvent être obtenues. On peut par exemple passer de la figure 5A à l'assemblage avec le sous-substrat donneur 2 pour obtenir des vias 32 creux sans paroi latérale 320 en matériau diélectrique. On peut par exemple passer de la figure 5B à l'assemblage avec le sous-substrat donneur 2 pour obtenir des vias 32 creux avec paroi latérale 320 et de fond 321 en matériau diélectrique.

Pour obtenir un via avec plusieurs portions présentant chacune une configuration, il est possible de faire une combinaison de gravures et de dépôt, voire de report de couche de substrat 1 pour boucher le via en partie arrière du substrat.

Le masque 12 peut être retiré suite à la formation du matériau diélectrique, voire suite au remplissage du via 32 par le matériau 323. En variante, le masque 12 peut être retiré préalablement à la formation de ces parois en matériau diélectrique. Dans le cas où la couche 11 a servi de masque dur il est préférable de la retirer également.

Le procédé peut comprendre, concomitamment ou suite à la formation des vias, une étape de formation du repère 34. Pour cela, le masque peut en outre comprendre des ouvertures, non représentées ici, pour graver par exemple des ouvertures dans la deuxième couche 31 jusqu'à dans la première couche 30. Les ouvertures peuvent être remplies du matériau diélectrique lors de la formation des parois. La formation du repère 34 peut être distincte de ces étapes, par l'application par exemple d'un masque spécifique à ce repère 34, gravure et remplissage des ouvertures. Si la formation du repère 34 est distincte de ces étapes, elle est avantageusement réalisée avant, pour servir de repère au positionnement des vias 32.

La formation des rainures 35 peut comprendre les mêmes étapes que pour la gravure des vias 32 et le cas échéant pour la formation des parois en matériau diélectrique. Les rainures 35 peuvent être formées simultanément aux vias 32, le masque 12 comprenant alors des ouvertures correspondant aux rainures 35 à graver. Les rainures 35 peuvent en alternative être gravées avant ou après la gravure des vias 32, par exemple par application d'un masque et une gravure spécifiques aux rainures 35. Selon un exemple, une fois les rainures 35 et vias 32 gravés, un matériau diélectrique peut être formé au niveau des parois 350, 351, 320, 321 comme précédemment décrit. En alternative, les rainures 35 peuvent être formées après la formation du matériau diélectrique au niveau des parois 320 et 321. On peut prévoir qu'une nouvelle formation de matériau diélectrique soit faite au niveau des parois 350, 351, selon les modalités précédemment décrites. La gravure des rainures 35 peut autrement ne pas être suivie d'une formation de matériau diélectrique au niveau des parois 350 et 351. Les rainures 35 et les vias 32 peuvent ne pas présenter de paroi en matériau diélectrique, selon une variante.

Suite à la formation des vias 32 et le cas échéant des rainures 35, ces structures peuvent être recouvertes pour être enterrées lors de l'assemblage du sous-substrat 1 avec un sous-substrat donneur 2. Le procédé peut donc comprendre la fourniture d'un sous-substrat donneur 2 présentant une surface exposée 2a'. Les modalités d'assemblage décrites ci-dessous peuvent s'appliquer à tous les exemples décrits précédemment.

Comme par exemple illustré par la figure 4D, les sous-substrats support 1 et donneur 2 peuvent être assemblés par la mise en contact par collage direct de leurs surfaces respectives 1a, 2a. Le substrat donneur 2 peut ensuite être aminci, par exemple par clivage par le procédé connu sous le nom de Smart-Cut^{®}.

L'assemblage peut pour cela comprendre, avant la mise en contact des surfaces 1a, 2a, la formation d'une zone de fragilisation 22 à une profondeur non nulle de la surface 2a du sous-substrat donneur 2. Cette zone de fragilisation 22 est par exemple formée par implantation d'ions, tels que des ions d'hydrogène et/ou d'hélium. Notons que toute autre technique de formation d'une zone de fragilisation, et notamment tout autre technique employée dans les procédés d'élaboration d'empilement de type SOI, peut être envisagée.

Suite à l'assemblage du sous-substrat support 1 et du sous-substrat donneur 2, le procédé peut comprendre la séparation d'une couche superficielle du sous-substrat donneur 2, au niveau de la zone de fragilisation 22, comme l'illustre le passage de la figure 4D à la figure 4E. Cette séparation peut être faite thermiquement ou mécaniquement, selon des étapes connues de la personne du métier.

Suite à la séparation, la surface 3a obtenue peut être irrégulière. Un polissage, lissage chimique ou guérison chimique et/ou mécanique et/ou thermique et/ou par faisceau ionique à base d'amas d'atomes ou à base de monomères de la surface 3a peut être réalisé, de sorte que la surface 3a présente une qualité cristalline et une rugosité adaptée pour d'autres procédés ultérieurs. Toute méthode de polissage mécano-chimique (CMP, abrégé de l'anglais *Chemical Mechanical Polishing*) ou thermique destinée à lisser une surface à base de semi-conducteur et notamment de silicium peut être envisagée.

Selon un exemple, le sous-substrat donneur 2 comprend une couche 20 à base ou faite d'un matériau semi-conducteur, par exemple en silicium et plus particulièrement en silicium monocristallin, ou d'un matériau piézoélectrique. Le sous-substrat donneur 2 peut comprendre en outre une couche 21 à base ou faite d'un matériau diélectrique, par exemple en silice SiO₂.

Selon un exemple, la couche 21 à base d'un matériau diélectrique peut former la couche superficielle du sous-substrat donneur 2. On peut notamment réaliser un collage direct de matériau diélectrique, par exemple oxyde de silicium, contre un matériau diélectrique, par exemple oxyde de silicium. Suite à leur assemblage, la couche 21 et la couche 11 vont former la deuxième couche 31 du substrat 3. Leurs épaisseurs respectives peuvent donc être choisies pour obtenir l'épaisseur L₃₁ voulue. Selon cet exemple, on comprend que la paroi supérieure 322 des vias 32 et le cas échéant la paroi supérieure 352 des rainures 35 peut être formée d'un matériau diélectrique.

En variante, on peut notamment réaliser un collage direct de matériau diélectrique, par exemple oxyde de silicium, contre le semi-conducteur de la couche 10 du sous-substrat support 1. Suite à leur assemblage, la couche 21 va former la deuxième couche 31 du substrat 3. Selon cet exemple, on comprend que la paroi supérieure 322 des vias 32 et le cas échéant la paroi supérieure 352 des rainures 35 peut être formée d'un matériau diélectrique.

Selon un exemple, la couche 20 peut former la couche superficielle du sous-substrat donneur 2. On peut réaliser un collage direct de matériau diélectrique, par exemple oxyde de silicium, contre semi-conducteur ou matériau piézoélectrique. Suite à leur assemblage, la couche 20 va former la deuxième couche 31 du substrat 3, et une couche intermédiaire de diélectrique est disposée entre la première couche 30 et la deuxième couche 31. Selon cet exemple, on comprend que la paroi supérieure 322 des vias 32 et le cas échéant la paroi supérieure 352 des rainures 35 peut être formée d'un matériau semi-conducteur ou piézoélectrique.

Selon un exemple, la couche 20 peut former la couche superficielle du sous-substrat donneur 2. On peut réaliser un collage direct de semi-conducteur ou piézoélectrique contre semi-conducteur, et notamment silicium, lorsque la couche 20 est à base d'un matériau semi-conducteur ou piézoélectrique. Suite à leur assemblage, la couche 20 va former la deuxième couche 31 du substrat 3.

Notons qu'il est préférable d'avoir pour l'assemblage une épaisseur de matériau diélectrique, et notamment d'oxyde, d'au moins 10 nm à l'interface de collage pour éviter l'apparition de défauts.

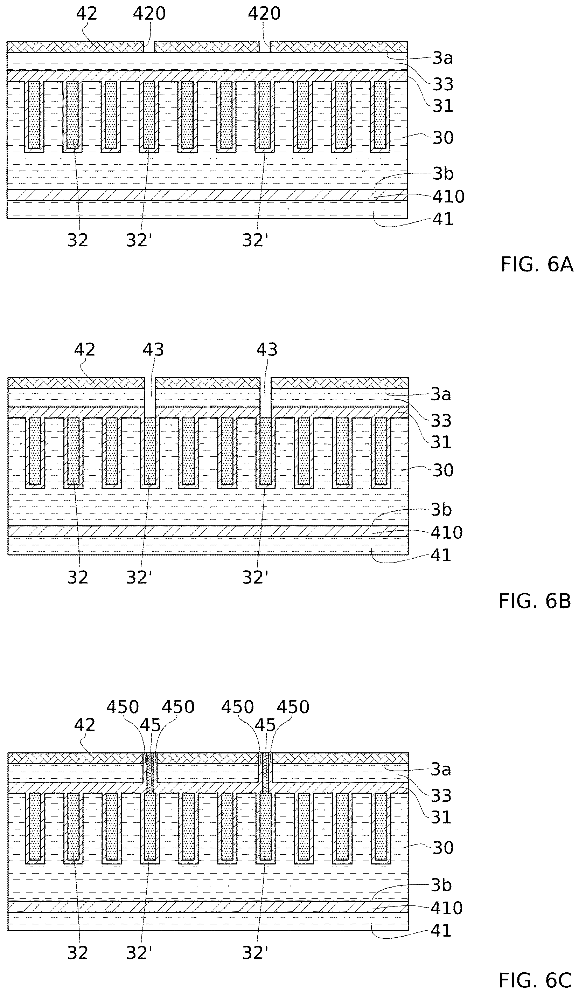

Le procédé de fabrication d'un dispositif microélectronique 4 est maintenant décrit en référence aux figures 6A à 8D.

Dans ce procédé, les vias 32 peuvent servir à établir des interconnexions. Les vias 32 peuvent en alternative ou en complément servir à former des portions d'un dispositif microélectronique sans nécessairement être des interconnexions métalliques, par exemple dans un dispositif MEMS.

Le procédé peut comprendre une fourniture du substrat 3. Le procédé peut comprendre le dépôt de couches de composants, par exemple de transistor, de diode, de point mémoire. Ce dépôt peut par exemple comprendre les étapes du FEOL.

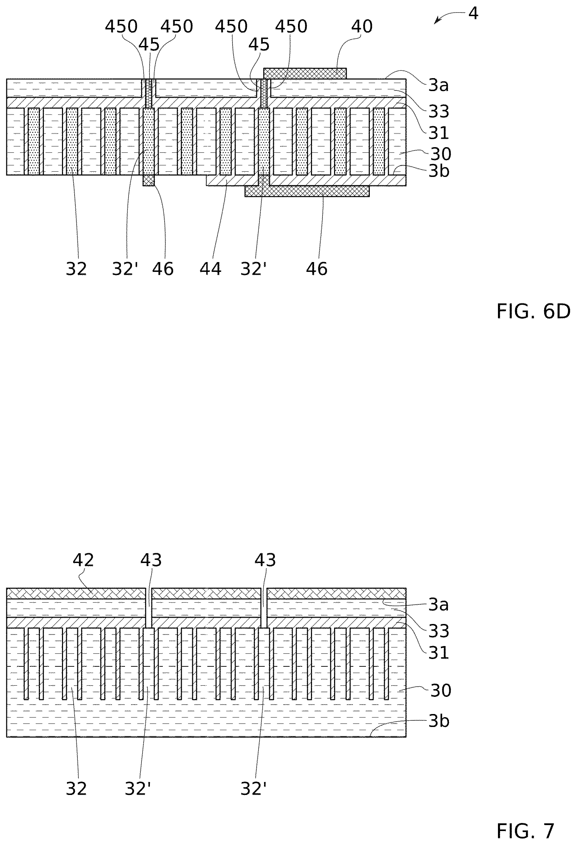

Comme par exemple illustré sur la figure 6D, le procédé peut comprendre le dépôt d'au moins une portion de couche 40, aussi appelé portion 40 de dispositif, sur la surface avant 3a du substrat 3. Dans la suite, on considère à titre non limitatif que plusieurs portions 40 sont déposées. En alternative ou en complément, la ou les portion(s) de dispositif peut/peuvent être gravée(s) dans la surface exposée avant 3a du substrat 3.

Ces portions peuvent être métalliques 40 et peuvent notamment former des lignes d'interconnexions métalliques. Typiquement ces portions métalliques 40 peuvent servir à redistribuer des signaux électriques. Ces portions métalliques peuvent aussi être désignées niveaux de métallisation. Il peut y avoir plusieurs portions métalliques 40 avec des interconnexions entre ces portions. Ce dépôt peut par exemple comprendre les étapes du BEOL.

Dans la suite, on considère à titre non-limitatif que ces portions 40 sont métalliques et que le via gravé 32 sert à établir une interconnexion. Les étapes suivantes s'appliquent tout à fait au cas où des portions 40 de dispositif 4 non métalliques sont déposées et/ou gravées.

Le dépôt d'au moins une portion de couche 40 peut être fait après la formation des vias 32 comme illustré, et le cas échéant après la formation des organes conducteurs ou semi-conducteurs 45, ou avant.

Afin de faciliter la manipulation du substrat 3, le procédé peut comprendre le montage d'un support 41 du côté de la surface avant 3a et/ou de la surface arrière 3a exposée du substrat 3, selon les étapes de fabrication. Ce montage peut être fait par exemple par le biais d'un collage 410, comme illustré par la figure 6B. Cela permet en outre de protéger les dépôts réalisés en surface du substrat 3. Le procédé peut en outre comprendre le démontage de ce support 41, par exemple lorsqu'il est nécessaire d'accéder à la surface re-couverte par le support 41 ou en fin de procédé

Le procédé comprend la gravure d'au moins un via 32 afin de réaliser au moins une mise en continuité électrique entre une portion 40, le via 32et la surface arrière 3b du substrat. Pour cela, plusieurs exemples sont possibles et sont maintenant décrits. Par souci de simplification des figures, les portions 40 ne sont pas représentées sur toutes les figures. Dans la suite, on considère à titre non limitatif que l'on grave plusieurs vias 32.

De préférence, le procédé comprend une sélection d'uniquement une partie des vias 32, pour définir un groupe de vias à graver 32'. Ainsi, à partir du substrat générique 3, on peut utiliser uniquement les vias d'intérêt pour la fabrication du dispositif microélectronique 4. Dans la suite, on considère à titre non-limitatif que le procédé comprend cette sélection et qu'une partie uniquement des vias 32 sont utilisés, et non la totalité.

Selon un premier exemple, comme illustré par la figure 6A à 6D, à partir de la surface avant 3a, une cavité 43 peut être créée pour atteindre les via 32'. Pour cela, un masque 42 peut être appliqué sur la surface avant du substrat 3. Le masque peut comprendre des ouverture 420 ou être gravé pour présenter les ouvertures 420. Le masque peut être un masque dur, par exemple à base ou fait de SiO₂. Le masque est par exemple déposé par PECVD.

Des cavités 43 peuvent être gravées de façon à atteindre les vias 32', et plus particulièrement de façon à atteindre et de préférence dépasser leur paroi supérieure 322, comme par exemple illustré par la figure 6A. Pour cela, une gravure silicium en SF₆ est par exemple effectuée. De préférence, la gravure ne met pas à jour le matériau conducteur du via 32' à ce moment-là afin d'éviter une contamination du substrat. Cela pourrait en effet être nuisible si des dispositifs actifs sont ensuite réalisés. Afin de mettre à jour le matériau conducteur 323 du via, le procédé peut comprendre une gravure RIE (abrégé de l'anglais *Reactive lon Etching,* que l'on peut traduire par gravure ionique réactive) pour ouvrir le fond de la cavité, aussi désignée « *etch back* »*.* Il est préférable que le matériau conducteur électriquement du via ne soit découvert qu'après la formation des parois diélectriques 450, décrite ultérieurement.

Une fois les cavités 43 formées, le procédé peut comprendre le dépôt d'un organe électriquement conducteur ou semi-conducteur 45. Cet organe 45 peut être à base ou fait d'un matériau métallique 45, par exemple du cuivre électrolytique ou du tungstène CVD. En alternative, cet organe 45 peut être à base ou fait d'un matériau semi-conducteur, par exemple du poly-Si. Le dépôt peut être configuré de façon à remplir ces cavités 43 du matériau métallique pour former une interconnexion électrique ou une portion de dispositif 40, comme par exemple illustré par la figure 6D.

À partir de la surface arrière 3b du substrat 3, la première couche 30 peut être gravée jusqu'à affleurer, ou dépasser la paroi de fond 321 des vias 32. Pour cela, la première couche 30 peut être amincie et gravée par une gravure du matériau de la première couche 30. L'ensemble de la surface arrière 3b du substrat 3 peut être gravée. Tous les vias 32 seront ainsi atteints.

Cette gravure peut selon un exemple être une gravure sélective du matériau de la couche 30 par rapport au matériau diélectrique des parois du via 32. La gravure peut par exemple être une gravure sélective du silicium par rapport à la silice SiO₂ en gravure ionique réactive utilisant un précurseur tel que SF₆. Par gravure « sélective d'un matériau A par rapport à un matériau B » on entend que la vitesse de gravure du matériau A est 10 et de préférence 100 fois supérieure à celle du matériau B. On peut également envisager la réalisation d'un amincissement mécanique partiel du substrat 3 terminé par une gravure plasma ou chimique sélective. La paroi en matériau diélectrique peut ensuite être gravée sélectivement par rapport au matériau de la première couche 30, pour déboucher dans le via 32'. Certains vias 32' uniquement peuvent être soumis à cette gravure sélective. Par exemple, la gravure du matériau diélectrique peut être une gravure ionique réactive. La gravure du matériau semi-conducteur peut être similaire à celle faite pour graver la couche 30.

En alternative ou en complément, on peut aussi envisager une gravure localisée à partir de la surface arrière 3b par le biais d'un masque présentant des ouvertures à l'aplomb des vias 32' à graver, et le remplissage des cavités gravées par un organe électriquement conducteur ou semi-conducteur.

De préférence, préalablement au dépôt de l'organe électriquement conducteur ou semi-conducteur en surface avant 3a et/ou surface arrière 3b du substrat 3, le procédé comprend la formation de paroi 450 en matériau diélectrique de façon à isoler cet organe des couches qu'il traverse, comme l'illustre la figure 6C par exemple. Les parois 450 peuvent être formé par un dépôt PECVD, par exemple de SiO₂. Ce dépôt est de préférence suffisamment conforme pour couvrir les flancs de la cavité 43. Cela permet d'éviter un court-circuit par le substrat 3.

Le procédé peut ensuite comprendre un dépôt configuré de façon à recouvrir par une couche métallique ou semi-conductrice 46 au moins une portion de la surface exposée arrière 3b du substrat 3, pour mettre en continuité la portion de dispositif 40, le via 32 et la face arrière 3b du substrat 3, comme illustré par exemple par la figure 6D.

Le procédé peut en outre comprendre au moins l'un parmi, de préférence entre la formation des cavités 43 et le dépôt de la couche 46 :
- le retrait du masque 42,
- une passivation de la surface arrière 3b exposée du substrat 3, par exemple par formation d'une couche de matériau diélectrique 44, aussi appelée couche de passivation 44. Cette formation peut être faite par dépôt d'un matériau diélectrique, par exemple comme décrit précédemment,
- une gravure de la couche 44 de façon à retirer une éventuelle couche d'oxyde qui se serait formé au niveau du via 32'. Cette éventuelle couche d'oxyde peut en effet limiter la reprise de contact électrique sur la portion 40.

Selon l'exemple illustré par la figure 7, ce procédé peut aussi s'appliquer à un via présentant une paroi latérale en matériau diélectrique et rempli par le même matériau que la première couche 30. Les mêmes étapes que décrites précédemment peuvent s'appliquer.

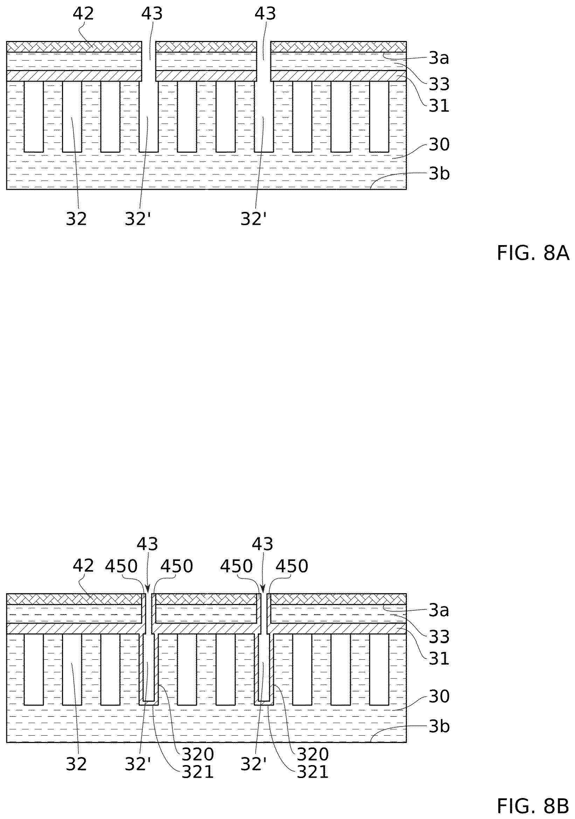

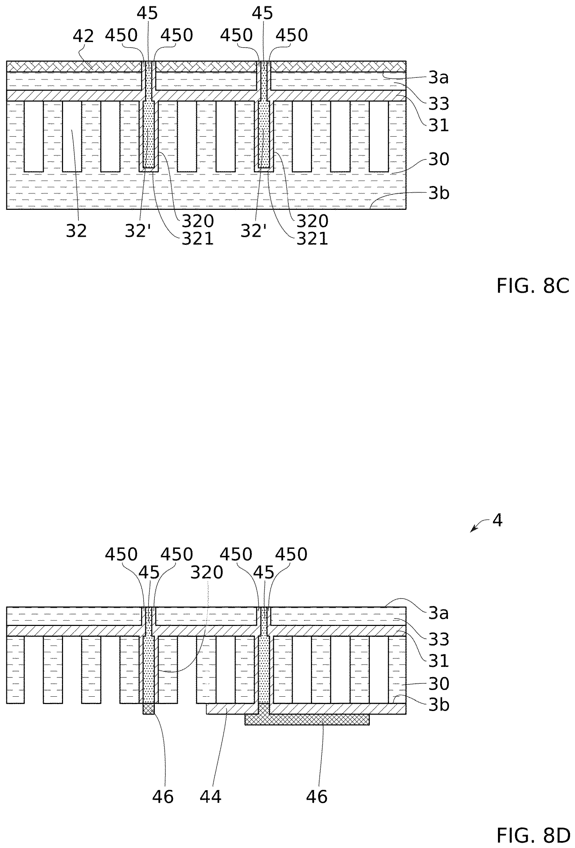

Les figures 8A à 8D décrivent un autre exemple dans lequel les via 32 sont creux. Comme décrit précédemment une cavité 43 peut être formée à l'aplomb des vias à graver 32', de façon à déboucher dans le via 32.

Lorsque les parois des vias 32' à graver ne sont pas en matériau diélectrique, le procédé peut comprendre la formation d'une couche diélectrique au niveau au moins de la paroi latérale 320, selon les modalités précédemment décrites en référence au procédé de fabrication du substrat 3. Cet exemple peut être illustré par la figure 8B. Des parois 450 en matériau diélectrique sont en outre avantageusement formées au niveau des cavités gravées 43.

Les vias 32' peuvent ensuite être remplis de l'organe électriquement conducteur ou semi-conducteur 45. Les étapes décrites ensuite en référence aux précédents exemples peuvent s'appliquer.

En variante, la gravure peut être effectuée depuis une face du substrat 3 jusqu'à déboucher dans le via 32', et poursuivie pour former au moins une cavité 43, par exemple une cavité de raccordement électrique 43 et atteindre l'autre face du substrat 3, que ce soit depuis la face avant ou la face arrière. Le procédé peut en outre comprendre les autres étapes décrites précédemment pour obtenir le dispositif illustré en figure 8D.

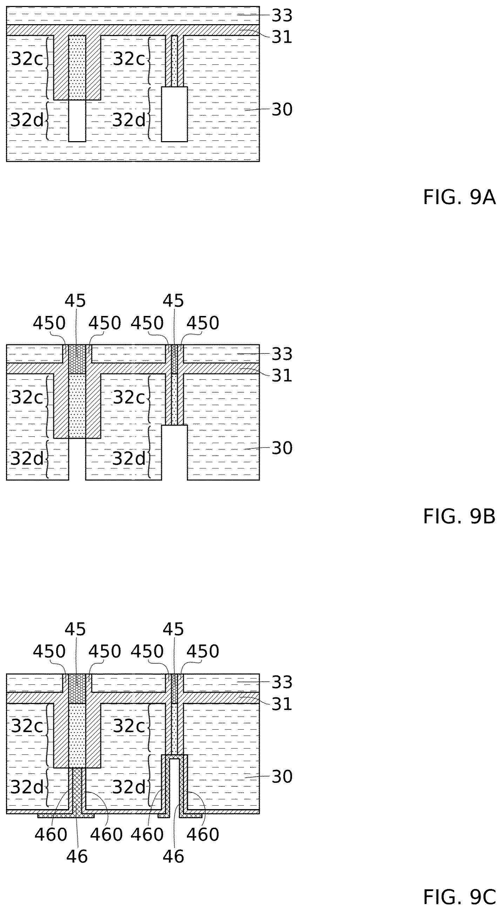

Comme illustré par les figures 9A à 9C, les exemples décrits peuvent s'appliquer également à l'exemple selon lequel les vias 32 présentent plusieurs tronçons de configuration le long d'un même via 32. Par exemple, une portion remplie par un matériau électriquement conducteur ou semi-conducteur peut être reliée par l'organe 45. Une portion creuse du via 32 peut être au moins en partie remplie par la couche 46 et/ou un autre organe 45, après formation d'une paroi en matériau diélectrique de façon à isoler le via 32.

Les exemples décrits peuvent s'appliquer également à l'exemple selon lequel les vias 32 comprennent des rainures 35. Afin de ne pas remplir les rainures de l'organe conducteur ou semi-conducteur, les ouvertures 420 du masque 42 peuvent être disposées de façon à ne pas permettre la gravure des rainures 35. Lors des étapes subséquentes à la formation des cavités 43, les rainures 35 restent de préférence closes et ne sont donc pas remplies par l'organe 45.

Au vu de la description qui précède, il apparaît clairement que l'invention propose un substrat, son procédé de fabrication et un procédé de fabrication d'un dispositif microélectronique permettant de faciliter la fabrication de vias dans un dispositif microélectronique.

L'invention n'est pas limitée aux modes de réalisations précédemment décrits et s'étend à tous les modes de réalisation couverts par l'invention. La présente invention ne se limite pas aux exemples précédemment décrits. Bien d'autres variantes de réalisation sont possibles, par exemple par combinaison de caractéristiques précédemment décrites, sans sortir du cadre de l'invention. En outre, les caractéristiques décrites relativement à un aspect de l'invention peuvent être combinées à un autre aspect de l'invention.

Notamment, le substrat peut présenter toute caractéristique résultant de son procédé de fabrication et inversement, ce procédé peut comprendre toute étape configurée pour obtenir une caractéristique du substrat. Le procédé de fabrication d'un dispositif microélectronique peut mettre en oeuvre toute caractéristique du substrat.

Dans les exemples décrits, le matériau semi-conducteur est en silicium. Notons que l'invention peut tout à fait s'appliquer à d'autres semi-conducteurs mono ou polycristallins, éventuellement dopés, et notamment au semi-conducteurs Si, Ge, SiGe, SiC, matériau III-V (par exemple AIN, GaN, InN, InGaAs, GaP, InP, InAs, AsGa...), et matériau II-VI. Le matériau diélectrique peut être un oxyde ou un nitrure de semi-conducteur, par exemple SiO₂, SiN, Al₂O₃. Le matériau piézoélectrique peut à titre d'exemple être choisi parmi le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), d'autres matériaux pouvant naturellement être envisagés.

## Revendications

1. Substrat (3) comprenant :
• une première couche (30) à base d'un matériau semi-conducteur,
• une deuxième couche (31) couche surmontant la première couche (30), le substrat (3) comprenant une pluralité de vias (32) enterrés s'étendant depuis la deuxième couche (31) sur une portion de la première couche (30), chaque via (32) étant délimité par une paroi latérale (320), une paroi de fond (321), et une paroi supérieure (322) opposée à la paroi de fond (321) , et en ce qu'au moins un ensemble (32a) de la pluralité de vias (32) forme un motif (32b) se répétant le long d'au moins une direction du plan d'extension principale des première (30) et deuxième (31) couches.

2. Substrat (3) selon la revendication précédente, dans lequel au moins une partie des vias (32) présente un rapport de forme supérieur ou égal à 10, de dimensions la plus longue orientée suivant une dimension en épaisseur des première (30) et deuxième (31) couches.

3. Substrat (3) selon l'une quelconque des revendications précédentes, dans lequel, au sein d'un ensemble (32a) de vias (32), deux motifs (32b) de vias (32) se répétant successivement sont séparés par un pas constant suivant au moins une direction du plan d'extension principale des première (30) et deuxième (31) couches, le pas étant compris entre 50 µm et 300 µm.

4. Substrat (3) selon l'une quelconque des revendications précédentes, dans lequel le substrat (3) comprend plusieurs ensembles (32a, 32a', 32a") de vias (32) formant chacun un motif (32b, 32b', 32b") se répétant le long d'au moins une direction du plan d'extension principale des première (30) et deuxième (31) couches.

5. Substrat (3) selon l'une quelconque des revendications précédentes, dans lequel au moins un via (32) présente au moins une configuration de via parmi les suivantes :
• la paroi latérale (320) du via (32) est faite d'un matériau diélectrique, et le via (32) est rempli d'un matériau électriquement conducteur ou semi-conducteur ou le via (32) est creux,
• la paroi latérale (320) du via (32) est faite d'un matériau diélectrique, et le via (32) est rempli du matériau de la première couche (30),
• la paroi latérale (320) du via (32) est faite du matériau de la première couche (30) et le via est creux.

6. Substrat (3) selon la revendication précédente, dans lequel au moins un via (32) présente une première configuration de via sur une première portion (32c), et une deuxième configuration de via distincte de la première configuration de via sur une deuxième portion (32d), les première (32c) et deuxième (32d) portions s'étendant successivement suivant une dimension en épaisseur des première (30) et deuxième (31) couches.

7. Substrat (3) selon l'une quelconque des deux revendications précédentes en combinaison avec la revendication 4, dans lequel au moins un ensemble (32a, 32a', 32a"présente au moins une configuration de via distincte d'un autre ensemble (32a, 32a', 32a").

8. Procédé de fabrication du substrat (3) selon l'une quelconque des revendications précédentes, comprenant :
• une fourniture d'un sous-substrat support (1) comprenant au moins une première couche (10) à base d'un matériau semi-conducteur, le sous-substrat support (1) présentant une surface exposée (1a),
• la formation d'une pluralité de vias (32) de sorte que les vias (32) s'étendent depuis la surface exposée (1a) sur une portion de la première couche (10), chaque via étant délimité par une paroi latérale (320) et une paroi de fond (321), au moins un ensemble (32a) de vias (32) formant un motif (32b) se répétant le long d'au moins une direction du plan d'extension principale des première (30) et deuxième (31) couches,
• une fourniture d'un sous-substrat donneur (2) comprenant une couche superficielle (20, 21) présentant une surface exposée (2a),
• un assemblage du sous-substrat support (1) et du sous-substrat donneur (2) par leurs surfaces exposées (1a, 2a), de façon à recouvrir les vias (32), chaque via étant alors délimité par la paroi latérale (320), la paroi de fond (321), et une paroi supérieure (322) opposée à la paroi de fond (321).

9. Procédé selon la revendication précédente dans lequel la formation de la pluralité de vias (32) comprend, pour au moins un ensemble de vias (32a) et sur au moins une première portion (32c) desdits vias (32), une gravure d'au moins un pourtour du via (32).

10. Procédé selon la revendication précédente, dans lequel la formation de la pluralité de vias (32) comprend, suite à la gravure au moins du pourtour du via (32), une formation d'un matériau diélectrique sur au moins le pourtour gravé du via (32) de façon à former la paroi latérale (320) du via (32) en matériau diélectrique.

11. **Procédé** selon la revendication précédente, dans lequel lors de la gravure d'au moins le pourtour du via (32), le via (32) est gravé sur sensiblement tout son volume, et la formation de la pluralité de vias (32) comprend, suite à la formation d'un matériau diélectrique sur au moins le pourtour gravé du via (32) de façon à former la paroi latérale (320) du via (32) en matériau diélectrique, un dépôt d'un matériau électriquement conducteur ou semi-conducteur (323) de façon à remplir au moins en partie le via.

12. Procédé de fabrication d'un dispositif microélectronique (4) comprenant :
• une fourniture d'un substrat (3) selon l'une quelconque des revendications 1 à 7 et/ou d'un substrat (3) fabriqué par le procédé selon l'une quelconque des revendications 8 à 11, présentant une surface exposée avant (3a) et une surface exposée arrière (3b),
• une formation d'au moins une portion de couche (40) du dispositif (4) par un dépôt, sur au moins l'une parmi les surfaces exposées avant (3a) ou arrière (3b) du substrat (3), de ladite portion, et/ou une gravure d'au moins l'une parmi les surfaces exposées avant (3a) ou arrière (3b) du substrat (3), configurée de façon à former ladite portion (40),
• au niveau d'au moins un via, une gravure par l'une parmi les surfaces exposées avant (3a) ou arrière (3b) du substrat (3), jusqu'à atteindre le via, et :
∘ poursuivre la gravure pour atteindre l'au moins une portion de couche (40) du dispositif (4), ou
∘ au niveau de l'au moins un via, une gravure par l'autre parmi les surfaces exposées avant (3a) ou arrière (3b) du substrat (3), jusqu'à atteindre le via,
• le dépôt d'au moins un organe électriquement conducteur ou semi-conducteur (45) de façon à mettre en continuité électrique au moins le via (32) et la portion de couche de dispositif (40).

13. Procédé selon la revendication précédente, dans lequel le procédé comprend, une sélection d'au moins un via à graver (32') parmi la pluralité de vias (32), uniquement une partie de la pluralité de vias (32) étant sélectionnée comme via à graver (32').

14. Procédé selon la revendication précédente, dans lequel la sélection de l'au moins un via à graver (32') comprend l'application, sur ladite surface exposée avant (3a) ou arrière (3b) du substrat (3), d'un masque (42) comprenant des ouvertures (420) situées à l'aplomb de l'au moins un via à graver (32'), suivie de la gravure de façon à atteindre l'au moins un via à graver (32').

15. Procédé selon l'une quelconque des deux revendications précédentes, dans lequel, lorsque le procédé met en œuvre la gravure par l'autre parmi les surfaces exposées avant (3a) ou arrière (3b) du substrat (3), jusqu'à atteindre le via, la sélection de l'au moins un via à graver (32') parmi la pluralité de vias (32) comprend l'application, sur ladite autre surface exposée avant (3a) ou arrière (3b) du substrat (3), d'un masque (42) comprenant des ouvertures (420) situées à l'aplomb de l'au moins un via à graver (32'), et le procédé comprend en outre une gravure de façon à atteindre l'au moins un via à graver (32').

## Patentansprüche

1. Substrat (3), umfassend:
• eine erste Schicht (30) auf Basis eines Halbleitermaterials,
• eine zweite Schicht (31) über der ersten Schicht (30),
wobei das Substrat (3) eine Vielzahl vergrabener Vias (32) umfasst, die sich von der zweiten Schicht (31) auf einem Teil der ersten Schicht (30) erstrecken, wobei jedes Via (32) von einer Seitenwand (320), einer Bodenwand (321) und einer oberen Wand (322), die der Bodenwand (321) entgegengesetzt ist, begrenzt ist, und dass mindestens eine Gruppe (32a) der Vielzahl von Vias (32) eine Struktur (32b) bildet, die sich entlang mindestens einer Richtung der Haupterstreckungsebene der ersten (30) und zweiten (31) Schicht erstreckt.

2. Substrat (3) nach dem vorstehenden Anspruch, wobei mindestens ein Teil der Vias (32) ein Seitenverhältnis größer oder gleich 10 aufweist, wobei die längste Abmessung entlang einer Dickenabmessung der ersten (30) und zweiten (31) Schicht ausgerichtet ist.

3. Substrat (3) nach einem der vorstehenden Ansprüche, wobei innerhalb einer Gruppe (32a) von Vias (32) zwei Strukturen (32b) von Vias (32), die sich nacheinander wiederholen, durch einen konstanten Abstand entlang mindestens einer Richtung der Haupterstreckungsebene der ersten (30) und zweiten (31) Schicht getrennt sind, wobei der Abstand zwischen 50 µm und 300 µm liegt.

4. Substrat (3) nach einem der vorstehenden Ansprüche, wobei das Substrat (3) mehrere Gruppen (32a, 32a', 32a") von Vias (32) umfasst, die jeweils eine Struktur (32b, 32b', 32b") bilden, die sich entlang mindestens einer Richtung der Haupterstreckungsebene der ersten (30) und zweiten (31) Schicht wiederholt.

5. Substrat (3) nach einem der vorstehenden Ansprüche, wobei das mindestens eine Via (32) mindestens eine Via-Konfiguration aus den Folgenden aufweist:
• die Seitenwand (320) des Vias (32) besteht aus einem dielektrischen Material, und das Via (32) ist mit einem elektrisch leitfähigen oder halbleitenden Material gefüllt, oder das Via (32) ist hohl,
• die Seitenwand (320) des Vias (32) besteht aus einem dielektrischen Material, und das Via (32) ist mit dem Material der ersten Schicht (30) gefüllt,
• die Seitenwand (320) des Vias (32) besteht aus dem Material der ersten Schicht (30) und das Via ist hohl.

6. Substrat (3) nach dem vorstehenden Anspruch, wobei mindestens ein Via (32) eine erste Via-Konfiguration auf einem ersten Teil (32c) und eine zweite Via-Konfiguration, die sich von der ersten Via-Konfiguration auf einem zweiten Teil (32d) unterscheidet, aufweist, wobei sich der erste (32c) und der zweite (32d) Teil nacheinander entlang einer Dickenabmessung der ersten (30) und zweiten (31) Schicht erstrecken.

7. Substrat (3) nach einem der beiden vorstehenden Ansprüche in Kombination mit Anspruch 4, wobei mindestens eine Gruppe (32a, 32a', 32a") mindestens eine Via-Konfiguration, die sich von einer anderen Gruppe (32a, 32a', 32a") unterscheidet, aufweist.

8. Verfahren zur Herstellung des Substrats (3) nach einem der vorstehenden Ansprüche, umfassend:
• eine Bereitstellung eines Trägeruntersubstrats (1), das mindestens eine erste Schicht (10) auf Basis eines Halbleitermaterials umfasst, wobei das Trägeruntersubstrat (1) eine freiliegende Oberfläche (1a) aufweist,
• das Bilden einer Vielzahl von Vias (32) derart, dass sich die Vias (32) von der freiliegenden Oberfläche (1a) auf einem Teil der ersten Schicht (10) erstrecken, wobei jedes Via von einer Seitenwand (320) und einer Bodenwand (321) begrenzt ist, wobei mindestens eine Gruppe (32a) von Vias (32) eine Struktur (32b) bildet, die sich entlang mindestens einer Richtung der Haupterstreckungsebene der ersten (30) und zweiten (31) Schicht wiederholt,
• eine Bereitstellung eines Donor-Untersubstrats (2), das eine oberflächliche Schicht (20, 21) umfasst, die eine freigelegte Oberfläche (2a) aufweist,
• eine Anordnung des Trägeruntersubstrats (1) und des Donor-Untersubstrats (2) an ihren freigelegten Oberflächen (1a, 2a) und derart, dass die Vias (32) abgedeckt werden, wobei jedes Via dabei von der Seitenwand (320), der Bodenwand (321) und einer oberen Wand (322), die der Bodenwand (321) entgegengesetzt ist, begrenzt ist.

9. Verfahren nach dem vorstehenden Anspruch, wobei das Bilden der Vielzahl von **Vias (32)** für mindestens eine Gruppe von Vias (32a) und auf mindestens einem ersten Teil (32c) der Vias (32) ein Ätzen mindestens eines Umfangs des Vias (32) umfasst.

10. Verfahren nach dem vorstehenden Anspruch, wobei das Bilden der Vielzahl von Vias (32) im Anschluss an das Ätzen mindestens des Umfangs des Vias (32) ein Bilden eines dielektrischen Materials auf mindestens dem geätzten Umfang des Vias (32) derart umfasst, dass die Seitenwand (320) des Vias (32) aus dielektrischem Material gebildet wird.

11. Verfahren nach dem vorstehenden Anspruch, wobei bei dem Ätzen mindestens des Umfangs des Vias (32) das Via (32) auf im Wesentlichen seinem gesamten Volumen geätzt wird, und das Bilden der Vielzahl von Vias (32) im Anschluss an das Bilden eines dielektrischen Materials auf mindestens dem geätzten Umfang des Vias (32) derart, dass die Seitenwand (320) des Vias (32) aus dielektrischem Material gebildet wird, ein Abscheiden eines elektrisch leitfähigen oder halbleitenden Materials (323) derart umfasst, dass das Via mindestens zum Teil gefüllt wird.

12. Herstellungsverfahren einer mikroelektronischen Vorrichtung (4), umfassend:
• ein Bereitstellen eines Substrats (3) nach einem der Ansprüche 1 bis 7 und/oder eines Substrats (3), das durch das Verfahren nach einem der Ansprüche 8 bis 11 gefertigt wird, das eine freigelegte vordere Oberfläche (3a) und eine freigelegte hintere Oberfläche (3b) aufweist,
• das Bilden mindestens eines Schichtteils (40) der Vorrichtung (4) durch ein Abscheiden auf mindestens einer der freigelegten vorderen (3a) oder hinteren (3b) Oberfläche des Substrats 3 des Teils und/oder ein Ätzen mindestens einer der freigelegten vorderen (3a) oder hinteren (3b) Oberfläche der Schicht des Substrats (3), die dazu konfiguriert ist, den Teil (40) zu bilden,
• auf der Ebene mindestens eines Vias ein Ätzen durch eine der exponierten vorderen (3a) oder hinteren (3b) Oberfläche des Substrats (3) bis zum Erreichen des Vias, und:
∘ Fortsetzen des Ätzens, um mindestens einen Schichtteil (40) der Vorrichtung (4) zu erreichen, oder
∘ auf der Ebene des mindestens einen Vias eines Ätzens durch die andere der freigelegten vorderen (3a) oder hinteren (3b) Oberfläche des Substrats (3), bis zum Erreichen des Vias,
• das Abscheiden mindestens eines elektrisch leitfähigen oder halbleitenden Elements (45) derart, dass mindestens das Via (32) und der Vorrichtungsschichtteil (40) elektrische Kontinuität aufweisen.

13. Verfahren nach dem vorstehenden Anspruch, wobei das Verfahren eine Auswahl mindestens eines zu ätzenden Vias (32') aus der Vielzahl von Vias (32) umfasst, wobei nur ein Teil der Vielzahl von Vias (32) als zu ätzendes Via (32') ausgewählt wird.

14. Verfahren nach dem vorstehenden Anspruch, wobei die Auswahl des mindestens einen zu ätzenden Vias (32') das Aufbringen einer Maske (42) auf der freigelegten vorderen (3a) oder hinteren (3b) Oberfläche des Substrats (3) umfasst, die Öffnungen (420) umfasst, die vertikal zu dem mindestens einen zu ätzenden Via (32') liegen, gefolgt vom Ätzen derart, dass das mindestens eine zu ätzende Via (32') erreicht wird.

15. Verfahren nach einem der beiden vorstehenden Ansprüche, wobei das Verfahren das Ätzen durch die andere der vorderen freigelegten vorderen (3a) oder hinteren (3b) Oberfläche des Substrats (3) bis zum Erreichen des Vias umsetzt, die Auswahl des mindestens einen zu ätzenden Vias (32') aus der Vielzahl von Vias (32) das Aufbringen einer Maske (42) auf der anderen freigelegten vorderen (3a) oder hinteren (3b) Oberfläche des Substrats (3) umfasst, die Öffnungen (420) umfasst, die vertikal zu dem mindestens einen zu ätzenden Via (32') liegen und das Verfahren außerdem das Gravieren bis zum Erreichen mindestens eines zu gravierendem Vias (32') umfasst.

## Claims

1. Substrate (3) comprising:
• a first layer (30) based on a semiconductive material,
• a second layer (31) surmounting the first layer (30),
the substrate (3) comprising a plurality of buried vias (32) extending from the second layer (31) over a portion of the first layer (30), each via (32) being delimited by a side wall (320), a bottom wall (321), and an upper wall (322) opposite the bottom wall (321), and in that at least one assembly (32a) of the plurality of vias (32) forms a pattern (32b) repeated along at least one direction of the main extension plane of the first (30) and second (31) layers.

2. Substrate (3) according to the preceding claim, wherein at least some of the vias (32) has an aspect ratio greater than or equal to 10, of the longest dimensions oriented along a dimension in thickness of the first (30) and second (31) layers.

3. Substrate (3) according to any one of the preceding claims, wherein, within a via (32) assembly (32a), two via (32) patterns (32b) repeated successively are separated by a constant pitch along at least one direction of the main extension plane of the first (30) and second (31) layers, the pitch being between 50µm and 300µm.

4. Substrate (3) according to any one of the preceding claims, wherein the substrate (3) comprises several via (32) assemblies (32a, 32a', 32a"), each forming a pattern (32b, 32b', 32b") repeated along at least one direction of the main extension plane of the first (30) and second (31) layers.

5. Substrate (3) according to any one of the preceding claims, wherein at least one via (32) has at least one via configuration from among the following:
• the side wall (320) of the via (32) is made of a dielectric material, and the via (32) is filled with an electrically or semiconductive material or the via (32) is hollow,
• the side wall (320) of the via (32) is made of a dielectric material, and the via (32) is filled with the material of the first layer (30),
• the side wall (320) of the via (32) is made of the material of the first layer (30) and the via is hollow.

6. Substrate (3) according to the preceding claim, wherein at least one via (32) has a first via configuration on a first portion (32c), and a second via configuration distinct from the first via configuration on a second portion (32d), the first (32c) and second (32d) portions extending successively along a dimension in thickness of the first (30) and second (31) layers.

7. Substrate (3) according to any one of the two preceding claims combined with claim 4, wherein at least one assembly (32a, 32a', 32a") has at least one via configuration distinct from another assembly (32a, 32a', 32a").

8. Method for manufacturing the substrate (3) according to any one of the preceding claims, comprising:
• a provision of a support sub-substrate (1) comprising at least one first layer (10) based on a semiconductive material, the support sub-substrate (1) having an exposed surface (1a),
• the formation of a plurality of vias (32) such that the vias (32) extend from the exposed surface (1a) over a portion of the first layer (10), each via being delimited by a side wall (320) and a bottom wall (321), at least one via (32) assembly (32a) forming a pattern (32b) repeated along at least one direction of the main extension plane of the first (30) and second (31) layers,
• a provision of a donor sub-substrate (2) comprising a superficial layer (20, 21) having an exposed surface (2a),
• an assembly of the support sub-substrate (1) and of the donor sub-substrate (2) by their exposed surfaces (1a, 2a), so as to cover the vias (32), each via thus being delimited by the side wall (320), the bottom wall (321), and an upper wall (322) opposite the bottom wall (321).

9. Method according to the preceding claim, wherein the formation of the plurality of vias (32) comprises, for at least one via (32a) assembly, and on at least one first portion (32c) of said vias (32), an etching of at least one perimeter of the via (32).

10. Method according to the preceding claim, wherein the formation of the plurality of vias (32) comprises, following the etching at least of the perimeter of the via (32), a formation of a dielectric material over at least the etched perimeter of the via (32), so as to form the side wall (320) of the dielectric material via (32).

11. Method according to the preceding claim, wherein during the etching of at least the perimeter of the via (32), the via (32) is etched over substantially its entire volume, and the formation of the plurality of vias (32) comprises, following the formation of a dielectric material over at least the etched perimeter of the via (32), so as to form the side wall (320) of the dielectric material via (32), a deposition of an electrically conductive or semiconductive material (323), so as to fill the via at least partially.

12. Method for manufacturing a microelectronic device (4) comprising:
• a provision of a substrate (3) according to any one of claims 1 to 7 and/or a substrate (3) manufactured by the method according to any one of claims 8 to 11, having a front exposed surface (3a) and a back exposed surface (3b),
• a formation of at least one layer portion (40) of the device (4) by a deposition, on at least one from among the front (3a) or back (3b) exposed surfaces of the substrate (3), of said portion, and/or an etching of at least one from among the front (3a) or back (3b) exposed surfaces of the substrate (3), configured so as to form said portion (40),
• at at least one via, an etching by one from among the front (3a) or back (3b) exposed surfaces of the substrate (3), until reaching the via, and:
∘ continuing the etching to reach the at least one layer portion (40) of the device (4), or
∘ at the at least one via, an etching by the other from among the front (3a) or back (3b) exposed surfaces of the substrate (3), until reaching the via,
• the deposition of at least one electrically conductive or semiconductive member (45), so as to provide electrical continuity to at least the via (32) and the device layer portion (40).

13. Method according to the preceding claim, wherein the method comprises, a selection of at least one via (32') to be etched from among the plurality of vias (32), only some of the plurality of vias (32) being selected as the via (32') to be etched.

14. Method according to the preceding claim, wherein the selection of the at least one via (32') to be etched comprises the application, on said front (3a) or back (3b) exposed surface of the substrate (3), of a mask (42) comprising openings (420) located in vertical alignment with the at least one via (32') to be etched, followed by the etching, so as to reach the at least one via (32') to be etched.

15. Method according to any one of the two preceding claims, wherein, when the method implements the etching by the other from among the front (3a) or back (3b) exposed surfaces of the substrate (3), until reaching the via, the selection of the at least one via (32') to be etched from among the plurality of vias (32) comprises the application, on said other front (3a) or back (3b) exposed surface of the substrate (3), of a mask (42) comprising openings (420) located in vertical alignment with the at least one via (32') to be etched, and the method further comprises an etching so as to reach the at least one via (32') to be etched.
